# EUROPÄISCHE PATENTSCHRIFT

(11) **EP 3 411 954 B1**
(45) Veröffentlichungstag und Bekanntmachung des Hinweises auf die Patenterteilung: **23.04.2025**
(21) Anmeldenummer: 16808594.2
(22) Anmeldetag: 01.12.2016
(51) Int. Cl.: H04B 1/00

(54) **FRONTEND-MODUL FUER CARRIER-AGGREGATION-BETRIEB**
FRONT END MODULE FOR CARRIER AGGREGATION OPERATION
MODULE FRONTAL POUR FONCTIONNEMENT EN MODE AGRÉGATION DE PORTEUSES

(30) Priorität: 05.02.2016 DE 102016102073
(43) Veröffentlichungstag der Anmeldung: 12.12.2018
(73) Patentinhaber: SnapTrack, Inc., San Diego, CA 92121 (US)
(72) Erfinder: FREISLEBEN, Stefan, 85579 Neubiberg (DE)
(74) Vertreter: Bardehle Pagenberg Partnerschaft mbB Patentanwälte Rechtsanwälte
(86) Internationale Anmeldenummer: PCT/EP2016/079483
(87) Internationale Veröffentlichungsnummer: WO 2017/133808

(56) Entgegenhaltungen:
- JP-A- 2006 108 824
- US-A1- 2014 368 401

## Beschreibung

Zur Steigerung der Datenübertragungsrate in Mobilfunksystemen sind Betriebsverfahren definiert, bei denen eine Gesprächsverbindung oder Datenübertragung synchron innerhalb zumindest zweier unterschiedlicher Frequenzbänder stattfindet.

Derartige Betriebsverfahren sind im Mobilfunk auch unter dem Namen Carrier Aggregation Mode bekannt. Diese nutzen zumindest drei FDD Frequenzbänder, von denen zumindest zwei Empfangsbänder/RX-Bänder sind, die gegebenenfalls mit einem oder mehreren Sendebändern/TX-Bändern kombiniert sind. Bei TDD Systemen ist Carrier Aggregation bereits mit zwei TDD Bändern möglich. Dazu werden die entsprechenden Signalpfade, in denen den Bändern zugeordnete Filter und insbesondere Duplexer angeordnet sind, parallel mit einer oder mehreren Antennen verbunden.

Insbesondere Lösungen mit nur einer Antenne erfordern dabei eine gute Signaltrennung mit geeigneten Multiplexern. Die Qualität der Frequenzauftrennung beim Parallelbetrieb in mehreren Bändern steigt mit dem Frequenzabstand der voneinander zu trennenden Bänder. Negativ beeinflusst wird die Signaltrennung durch enge Bandabstände und auch durch hohe Multiplexstufen, also Multiplexer, die mehr als zwei Bänder voneinander trennen. Dies kann üblicherweise nur mit hochfrequenzgenauen Filtern und Duplexern und einer aufwändigen Anpassungsschaltung erreicht werden. Beispiele sind in den Druckschriften US 2014/368401 A1 und JP 2006 108824 A gezeigt.

Für eine Lösung mit zwei Antennen ist für einen Carrier Aggregation Mode mit drei Empfangsbändern zumindest ein zellularer Quadplexer erforderlich. Nachteilig an dieser Lösung ist, dass metallische Gehäuse problematisch für Mobilfunkgeräte mit mehreren Antennen sind.

Für die Lösung mit einer Antenne ist ein Frontend-Modul erforderlich, welches zumindest einen zellularen Hexaplexer umfasst. Ein Hexaplexer weist aber einen komplexen Aufbau auf, der mit hohen Kosten verbunden ist.

Eine weitere Lösung für den Carrier-Aggregation-Betrieb mit nur einer Antenne erfordert einen Triplexer, der beispielsweise die Bandbereiche LB (Low Band), MB (Mid Band) und HB (High Band) voneinander trennt. Problematisch an dieser Lösung ist jedoch der schmale Abstand zwischen dem Mid Band, welches bei 2200 MHz endet, und dem High Band, welches ab 2300 MHz beginnt. Kostengünstige Lösungen hochintegrierter, z. B. in LTCC realisierter Triplexer, sind für diese Aufgabenstellung daher nur schwer realisierbar.

Im Carrier-Aggregation-Betriebsverfahren, bei dem mehrere Empfangskanäle verbunden werden, ist es wichtig, dass die Signalpfade sich nicht gegenseitig blocken oder dass die Signale nicht in das jeweilige andere Band hineinlecken, was mit höheren Leistungsverlusten und damit einer höheren Einfügedämpfung verbunden wäre. Ähnliches gilt für einen Carrier Aggregation Mode, bei dem mehrere Sendebänder für eine Kommunikationsverbindung parallel betrieben werden.

Ein weiteres Problem besteht darin, dass eine Vielzahl von Bandkombinationen für den Carrier Aggregation Mode in der Diskussion sind, die gegebenenfalls parallel in entsprechenden Frontend-Modulen implementiert sein müssen. Dies erschwert die Bändertrennung zusätzlich.

Aufgabe der vorliegenden Erfindung ist es, ein Frontend-Modul anzugeben, welches für einen Carrier-Aggregation-Betrieb ertüchtigt ist und mit dem die Bändertrennung mit einfacheren Mitteln und geringeren Verlusten möglich ist.

Diese Aufgabe wird erfindungsgemäß durch ein Frontend-Modul nach Anspruch 1 gelöst. Vorteilhafte Ausgestaltungen der Erfindung gehen aus abhängigen Ansprüchen hervor. Formulierungen wie "kann" und "zum Beispiel", die in der Beschreibung in Verbindung mit Merkmalen des unabhängigen Anspruchs verwendet werden, sollten nicht so ausgelegt werden, dass diese Merkmale lediglich optional sind.

Grundlegende Idee der Erfindung ist es, in einem ersten Signalpfad, der mit einem Antennenanschluss gekoppelt ist, einen Diplexer (oder höheren Multiplexer) vorzusehen, der einen ersten und einen zweiten Frequenzbereich voneinander trennt und ausgangsseitig einem ersten bzw. einem zweiten Teilpfad zuweist. Der Diplexer weist bauartbedingt einen ersten Diplexerabstand auf. Unter Diplexerabstand wird der Minimalabstand zweier an den Diplexereingang anlegbaren Signale verstanden, die am Ausgang des Diplexers mit geringer Dämpfung voneinander trennbar sind und so unterschiedlichen Teilpfaden zugewiesen werden können.

Weiter wird ein an den Diplexer gekoppeltes Notch-Filter vorgesehen, welches einen ersten Sperrbereich aufweist. Das Notch-Filter ist zwischen dem Antennenanschluss und dem Diplexer gekoppelt. Erfindungsgemäß wird das Notch-Filter so ausgestaltet, dass sein Sperrbereich zwischen dem ersten und dem zweiten Frequenzbereich angeordnet ist, aber mit keinem der beiden angrenzenden Frequenzbereiche überlappt. Auf diese Weise gelingt es, den Diplexer für Signale innerhalb des Sperrbereichs undurchlässig zu machen. Dabei werden die zueinander weisenden Flanken der beiden Durchlassbereiche des Diplexers versteilert und somit schärfer begrenzte Passbandgrenzen erhalten.

Ein erster Extraktorpfad ist an einen im Signalpfad zwischen Antennenanschluss und erstem Notch-Filter angeordneten Knoten angekoppelt. Innerhalb des Sperrbereichs liegende Signale können so über den ersten Extraktorpfad aus der Signalleitung extrahiert werden.

Im Extraktorpfad ist außerdem ein Bandpassfilter angeordnet, welches für das Extraktorband durchlässig ist, andere Frequenzen aber dämpft. Erfindungsgemäß überlappt der Sperrbereich des Notch-Filters zumindest teilweise mit dem Extraktorband. Notch-Filter und Extraktorpfad bilden zusammen eine Extraktor-Anordnung, mit der innerhalb des Extraktorbandes liegende Signale aus dem Signalpfad extrahiert werden können.

Das vorgeschlagene Frontend-Modul hat den Vorteil, dass der Diplexer mit relativ hohem Diplexerabstand realisiert werden kann, was technisch einfacher möglich ist als bei geringerem Diplexerabstand. Zwischen erstem und zweitem Frequenzbereich liegende Signale gehen dabei aber nicht verloren, da sie über den Extraktorpfad ausgekoppelt werden können. Zusammen bilden Diplexer und Extraktor-Anordnung einen Triplexer, der ein Extraktorband, einen ersten und einen zweiten Frequenzbereich voneinander trennen kann.

Der Diplexer des erfindungsgemäßen Frontend-Moduls kann daher als Kombination eines Hochpasses und eines Tiefpasses in einfacher Weise in LTCC oder in einem Laminat realisiert werden. Möglich ist es natürlich auch, ihn als diskretes Filter aus SMD-Induktivitäten und SMD-Kapazitäten auszubilden.

Gemäß einer Ausführungsform ist im ersten Signalpfad zwischen dem ersten Antennenanschluss und dem Notch-Filter ein zweiter Diplexer oder ein höherer Multiplexer angeordnet, der zumindest einen dritten Frequenzbereich aus dem ersten Signalpfad abtrennt und in einen dritten oder gar weiteren Teilpfad leitet. Damit kann das Frontend-Modul über die drei Teilpfade drei Frequenzbereiche und über den Extraktorpfad ein Extraktorband sauber voneinander trennen. Somit ist es möglich, die drei Frequenzbereiche und das Extraktorband unabhängig voneinander und auch parallel zu betreiben, ohne dass gegenseitige Störungen stattfinden. Die Frequenzbereiche und das Extraktorband können außerdem mit minimalen Verlusten gegeneinander isoliert werden.

Gemäß einem Ausführungsbeispiel ist der Sperrbereich des Notch-Filters bzw. das Extraktorband so gelegt, dass es mit dem RX-Band von Band 1 und/oder Band 4 und/oder Band 66 vollständig überlappt. Da das Rx Band von Band 66 exakt den gleichen Frequenzbereich belegt wie Band 65, liegt natürlich auch das das Rx Band von Band 66 gemäß dieser Ausführung im Sperrbereich des Notchfilters. Ein Filter für Band 4 Rx kann hier und in allen anderen Ausführungsbeispielen so ausgelegt sein, dass es zusätzlich noch die breiteren Bänder Band 1 Rx oder auch noch Band 65/66 Rx mit umfasst. Alle vier Bänder sind im selben schmalen Frequenzband zwischen 2110 MHz und 2200 MHz angesiedelt. Entsprechend ist das Bandpassfilter im Extraktorpfad für das RX-Band von Band 1 und/oder Band 4 und/oder Band 65/66 ausgebildet. Auch im Folgenden gilt, dass jegliche Erwähnung des Rx Bands von Band 66 zugleich das Rx Band von Band 65 mit umfassen soll und dass ein für Band 66 RX nutzbares Filter immer auch für Band 65 RX nutzbar ist.

Für den ersten Diplexer ist es dann ausreichend, wenn der erste Frequenzbereich Frequenzen bis 1995 MHz oder alternativ - unter Einschluss von Band 34 - bis 2025 MHz umfasst. Entsprechend kann der zweite Frequenzbereich dann Frequenzen von > 2300 MHz umfassen.

Für ein Frontend-Modul ohne Extraktor-Anordnung, welches die RX-Bänder von Band 1 und/oder Band 4 und/oder Band 66 umfasst, wäre ohne die Erfindung ein Diplexer mit einem Diplexerabstand von 100 MHz erforderlich, der sich von 2200 MHz bis 2300 MHz erstreckt. Da die genannten Frequenzen der RX-Bänder 1, 4 und 66 über den Extraktorpfad ausgeleitet werden, ist für den Diplexer ein Diplexerabstand von 305 MHz (bzw. 275 MHz) ausreichend, nämlich von 1995 MHz bis 2300 MHz (bzw. von 2025 MHz bis 2300 MHz). Dies erleichtert die technische Realisierung des Diplexers in LTCC oder Laminattechnologie. Möglich ist natürlich auch eine Realisierung in einer beliebigen anderen Technologie, die beispielsweise diskrete Filter unter Verwendung von SMD-Bauelementen umfasst.

Gemäß einer weiteren Ausführungsform wird das Extraktorband zur Extraktion der Frequenzen von Band 30 (Rx und Tx) und/oder Band 40 ausgelegt, welches ein TDD Band ist. Dementsprechend liegt der Sperrbereich des Notch-Filters so, dass er die beiden schmalen RX-und Tx Bänder von Band 30 und/oder das breitere Band 40 vollständig überlappt. All diese Bänder sind einander teilweise überlappend im Frequenzbereich zwischen 2300 und 2400 MHz angesiedelt. Dementsprechend kann das Bandpassfilter im Extraktorpfad für das RX-Band von Band 30 und/oder Band 40 ausgebildet sein. Auch für alle weiteren Ausführungsbeispiele gilt, dass ein Filter für Band 40 gleichzeitig auch für die Frequenzen von Band 30 Rx und Tx ausgelegt ist. Umgekehrt kann ein Band 30 Filter mittels eines entsprechend breiteren Bands zusätzlich noch für Band 40 ausgelegt werden. Indem die Frequenzen für die RX-Bänder von Band 30 und/oder Band 40 dem Extraktorpfad zugewiesen werden, ist es möglich, den Diplexerabstand auf einen Bereich von 2200 MHz bis 2496 MHz zu erweitern. Ohne Extraktion der RX-Frequenzen von Band 30 und/oder Band 40 wäre ein Diplexer mit einem Diplexerabstand von nur 100 MHz erforderlich, der im Bereich von 2200 MHz bis 2300 MHz anzusiedeln wäre. Auch hier ermöglicht der große Diplexerabstand die technologisch einfache technische Realisierung des Diplexers.

In weiterer Ausgestaltung der Erfindung ist im ersten Signalpfad oder in einem der Teilpfade, ausgewählt aus erstem, zweitem und drittem Teilpfad, ein zweites Notch-Filter angeordnet. Dieses weist einen zweiten Sperrbereich auf und bildet zusammen mit einem zweiten Extraktorpfad, in dem ein zweites Bandpassfilter angeordnet ist, eine zweite Extraktor-Anordnung. Der Durchlassbereich des zweiten Bandpassfilters entspricht einem zweiten Extraktorband. Zweiter Sperrbereich und zweites Extraktorband überlappen zumindest teilweise. Auf diese Weise gelingt es, zwei gegebenenfalls schmalbandige Frequenzbänder unabhängig von den Diplexern zu extrahieren, sodass die verbliebenen Bänder besser separiert und gegeneinander isoliert werden können.

Vorteilhaft entspricht das zweite Extraktorband einem reinen Rx Signal, welches über eine Extraktor-Anordnung besonders gut herausgefiltert werden kann. Dies beruht auf der hohen Reflexion des Notch-Filters für innerhalb des Sperrbereichs liegende Frequenzen. Diese Frequenzen können die Extraktor-Anordnung nur über den Extraktorpfad passieren und nicht über den Pfad, in dem das Notch-Filter angeordnet ist. Die Extraktion gelingt daher mit hohem Wirkungsgrad bzw. niedriger Dämpfung.

In einer Ausführungsform sind im Frontend-Modul zwei Extraktor-Anordnungen, vorgesehen, die zum Extrahieren von jeweils einem Extraktorband ausgebildet sind. Das erste Extraktorband umfasst das RX-Band von Band 66 und/oder Band 1. Das zweite Extraktorband ist für Frequenzen ausgelegt, die ausgewählt sind aus GNSS, WLAN 2.4, Band 40, Band 30 RX, Band 32 RX und LMB. LMB steht dabei für "Lower Mid Band" und umfasst Frequenzen von 1425 MHz bis 1511 MHz. Mit einem solchen Frontend-Modul gelingt es, die Frequenzen der zwei Extraktorbänder aus dem gesamten Frequenzspektrum zu extrahieren.

Eine in einem Signalpfad angeordnete Extraktor-Anordnung erhöht die Einfügedämpfung im Signalpfad nur unwesentlich. Es ist daher möglich, eine höhere Anzahl von Extraktor-Anordnungen vorzusehen, ohne dass die Einfügedämpfung in den verbleibenden Frequenzbereichen unzulässig erhöht ist.

Gemäß einer Ausführungsform der Erfindung sind daher drei Extraktor-Anordnungen vorgesehen, die zum Extrahieren von zusammen drei unterschiedlichen Extraktorbändern ausgebildet sind. Das erste Extraktorband umfasst dabei das RX-Band von Band 66 und/oder das RX-Band von Band 1. Das zweite und das dritte Extraktorband sind für Frequenzen ausgelegt, die unabhängig voneinander aus GNSS, WLAN 2.4, Band 40 RX, Band 30 RX, Band 32 RX und LMB ausgewählt sind.

Die für die Extraktor-Anordnungen verwendeten Filter, also jedes Notch-Filter und jedes der in einem der Extraktorpfade angeordneten Bandpassfilter umfassen gemäß einer Ausführungsform der Erfindung mikroakustische Resonatoren, die ein SAW-Filter, ein temperaturkompensiertes SAW-Filter oder ein BAW-Filter realisieren. Unter einem temperaturkompensierten SAW-Filter wird ein SAW-Filter verstanden, welches einen mit Hilfe einer Kompensationsschicht reduzierten Temperaturkoeffizienten der Frequenz aufweist.

Ein temperaturkompensiertes SAW-Filter weist beispielsweise eine SiO2-Schicht über den Elektrodenstrukturen auf, deren Dicke ca. 20 bis 30 % der im jeweiligen Material ausbreitungsfähigen akustischen Wellenlänge X beträgt.

Das Bandpassfilter in den Extraktorpfaden kann beispielsweise eine Laddertype-Anordnung mikroakustischer Resonatoren oder DMS Spuren umfassen.

Das Notch-Filter kann ebenfalls als Laddertype-Anordnung ausgeführt sein, wobei die parallelen oder seriellen Resonatoren teilweise oder ganz durch Spulen ersetzt sein können. Möglich ist es jedoch auch, jeweils einen einzelnen Resonator als Notch-Filter einzusetzen, wobei der Sperrbereich eines solchen aus einem mikroakustischen Resonator gebildeten Notch-Filter im Bereich der Antifrequenz des Resonators liegt.

Die im erfindungsgemäßen Frontend-Modul eingesetzten Diplexer umfassen jeweils ein Tiefpassfilter und ein Hochpassfilter. Möglich ist es auch, ein oder zwei der Filter des Diplexers als Bandpassfilter auszuführen. Die Filter können jeweils aus L- und C-Elementen realisiert sein. Möglich ist es dabei, die L- und C-Elemente in einer LTCC-Keramik oder in einem Laminat zu integrieren, beispielsweise in Form von Leiterbahnen und strukturierten Metallisierungen. Möglich ist es jedoch auch, die Filter des Diplexers aus diskreten L- und C-Elementen zu realisieren, die zusammen auf einem Träger montiert sind und dabei wieder ein unabhängig händelbares Bauelement darstellen.

Gemäß einer weiteren Ausführungsform wird zumindest eine der Extraktor-Anordnungen mit einem Überbrückungspfad, in dem ein Schalter zum Öffnen oder Schließen des Überbrückungspfads angeordnet ist, überbrückt. Damit ist es möglich, durch Öffnen des Schalters im Überbrückungspfad die Extraktion des Extraktionsbandes zu verhindern. Da so auch das Notchfilter überbrückt wird, können Signale im Bereich des Extraktionsbandes den Signalpfad unreflektiert bzw. ungedämpft passieren. Auf diese Weise gelingt es, die durch die Extraktor-Anordnung in Kauf zu nehmende Impedanzerhöhung im Signalpfad immer dann zu vermeiden, wenn auf das Extraktionsband nicht zugegriffen werden muss. Immer dann kann der Überbrückungspfad geöffnet werden.

Dabei ist es möglich, eine jede der Extraktor-Anordnungen des Frontend-Moduls mit einem solchen Überbrückungspfad zu versehen, der über einen jeweiligen Schalter freigeschaltet oder gesperrt werden kann.

In weiterer Ausgestaltung der Erfindung wird ein jeder der Teilpfade mit dem Eingang eines Antennenschalters verbunden. Für jeden Teilpfad kann dabei ein separater Antennenschalter vorgesehen sein. Möglich ist es jedoch auch, sämtliche Teilpfade mit einem gemeinsamen Antennenschalter zu verbinden.

Über eine entsprechende Schalterstellung des Antennenschalters wird der Ausgang des Antennenschalters mit einem Bandkanal verbunden, in dem ein Filterelement für das jeweilige dem Bandkanal zugeordnete Band angeordnet ist. Üblicherweise umfasst ein solches Filterelement einen Duplexer, d.h. immer dann, wenn das Band ein FDD Verfahren nutzt und kein reines Empfangsband ist.

In einer Ausführung wird ein neuartiger gemischter Duplexer eingesetzt, der ein RX-Filter für ein beliebiges erstes Band und ein TX-Filter für ein davon verschiedenes beliebiges zweites Band kombiniert. Auf diese Weise ist es möglich, RX- und TX-Frequenzen eines Bandes über verschiedene Filterelemente zu leiten, die in unterschiedlichen Pfaden bzw. Bandkanälen angeordnet sind.

Wenn beispielsweise das Extraktorband die RX-Frequenzen des zweiten Bandes umfasst, ist es möglich, die RX-Frequenzen des zweiten Bands über den Extraktorpfad zu extrahieren, die Tx-Frequenzen dagegen über einen gemischten Duplexer, der mit dem Ausgang des Antennenschalters verbunden ist. So ist dann an einem anderen Ausgang des Antennenschalters ein reiner Duplexer vorgesehen, der ein TX-Filter und ein dazugehöriges RX-Filter für das erste Band umfasst. Dadurch gelingt es, die RX-Frequenzen des ersten Bandes wahlweise über den gemischten Duplexer oder den reinen Duplexer zu filtern. Das RX-Signal des zweiten Bandes wird ausschließlich über den Extraktorpfad erhalten. Dadurch stehen die Rx Bänder des ersten und zweiten Bandes immer gleichzeitig zur Verfügung, wie für Downlink Carrier Aggregation erforderlich. Im Folgenden wird unter Carrier Aggregation immer Downlink 5Carrier Aggregation verstanden, sofern sich ein Beispiel nicht ausdrücklich auf Uplink Carrier Aggregation bezieht.

In einer speziellen Ausführungsform ist in einem gemischten Duplexer ein TX-Filter für Band 1 mit einem RX-Filter für Band 3 oder ein TX-Filter für Band 4 mit einem RX-Filter für Band 2 kombiniert. Parallel dazu ist ein Extraktorband mit einem Band 4 RX-Filter oder mit einem Band 1 RX-Filter oder einem Band 65/66 RX-Filter als Bandpassfilter versehen. Eine weitere mögliche Ausführung für einen gemischten Duplexer kombiniert Band 3 Rx und Band 65 Tx.

Gemäß einer Ausführungsform ist ein gemischter Duplexer vorgesehen der ein TX-Filter für Band 1 mit einem RX-Filter von Band 3, oder ein TX-Filter von Band 65 mit einem RX-Filter von Band 3, oder ein TX-Filter von Band 4 mit einem RX-Filter von Band 2, oder ein TX-Filter von Band 4 mit einem RX-Filter von Band 25, oder ein TX-Filter von Band 66 mit einem RX-Filter von Band 2, oder ein TX-Filter von Band 66 mit einem RX-Filter von Band 25 kombiniert. Ein solcher gemischter Duplexer ist mit einer Extraktor-Anordnung kombiniert, bei der das Extraktorband für RX-Frequenzen von Band 4 oder für RX-Frequenzen von Band 1 oder für RX-Frequenzen von Band 65/66 ausgelegt ist. Zusätzlich sind reine Duplexer vorgesehen, die das Rx-Band der oben gelisteten gemischten Duplexer mit dem korrespondierenden Tx-Band kombinieren und ausgewählt sein können aus den Duplexern für B3-Tx/B3-Rx, B2-Tx/B2-Rx und B25-Tx und B25-Rx.

In einer speziellen Ausführungsform kann der Ausgang des Antennenschalters über entsprechende Schalterstellungen wahlweise mit einem Triplexer oder einem Duplexer verbunden werden. Der erste Triplexer ist als gemischter Triplexer ausgebildet und umfasst ein TX-Filter für Band 1, ein RX-Filter für Band 3 und ein RX-Filter für Band. Alternativ umfasst der erste Triplexer ein TX-Filter für Band 65, ein RX-Filter für Band 3 und ein RX-Filter für Band 32. Ein weiterer Triplexer, umfasst ein TX-Filter für Band 3, ein RX-Filter für Band 3 und ein RX-Filter für Band 32. Die im gemischten Triplexer noch fehlenden RX-Bänder, die den dort bereits vorhanden Tx Filtern zugeordnet sind, werden über die Extraktor-Anordnungen bzw. die entsprechenden Extraktorpfade ausgefiltert bzw. extrahiert. Dementsprechend umfasst eine Extraktor-Anordnung ein RX-Filter für Band 4 oder ein RX-Filter für Band 1 oder ein RX-Filter für Band 65/66.

Ein solcher gemischter Triplexer ist vorteilhaft mit einem gemischten Duplexer kombiniert, der an einen anderen Ausgang des Antennenschalters angeschlossen ist und ein TX-Filter für Band 1 und ein RX-Filter für Band 11 oder das dem Band 11 direkt benachbarte Band 21 Rx umfasst. Es ist daher sinnvoll, alle entsprechenden Rx Filter für Band 11 oder Band 21 entsprechend breit auszubilden, um beide Bänder bedienen zu können. Alternativ ist ein TX-Filter für Band 1 mit einem RX-Filter für Band 11 kombiniert.

In weiterer Ausgestaltung kann der gemischte Duplexer ein TX-Filter für Band 1 oder 65 und ein RX-Filter für Band 21 umfassen. Band 1 Tx ist vollständig in dem breiteren Band 65 Tx enthalten, so dass Band 1 Tx immer von einem Band 65 Tx Filter mit bedient werden kann. Entsprechend sind diesem gemischten Duplexer RX-Filter in einem Extraktorband zugeordnet, beispielsweise ein RX-Filter für Band 4, Band 1 oder Band 65. Weiterhin ist im Frontend-Modul in diesem Fall noch ein reiner Duplexer für Band 11 oder Band 21 vorgesehen. Auf diese Weise ist es möglich, RX-Bänder für Band 11 oder Band 21 wahlweise über den reinen Duplexer oder den gemischten Duplexer zu filtern.

In einer alternativen Ausführung kann der Ausgang des Antennenschalters über eine entsprechende Schalterstellung mit einem Triplexer oder einem Duplexer verbunden werden. Der Triplexer kann beispielsweise eine Filterkombination eines TX-Filters für Band 1 oder 65/66, eines TX-Filters für Band 3 und eines RX-Filters für Band 3 umfassen. Alternativ kann der Triplexer eine Filterkombination eines TX-Filters für Band 2 oder Band 25, deren Bänder beide nahezu deckungsgleich sind, eines RX-Filters für Band 4 oder Band 65/66 und eines RX-Filters für Band 2 oder Band 25 umfassen. Für diese Ausführung ist ein Extraktorband dem RX-Band von Band 4 oder dem RX-Band von Band 1 oder dem RX-Band von Band 66 zugeordnet. Auch in dieser Ausführung erfolgt der Duplex-Betrieb für das jeweilige Band (Band 1, Band 4 oder Band 66) über zwei getrennte Filter und damit über zwei getrennte Pfade, von denen ein Pfad der Extraktorpfad ist. Diese Ausführung kann auch für Uplink Carrier Aggregation genutzt werden. Allgemein gilt für dieses und weitere Ausführungsbeispiele, dass RX und Tx Filter für Band 25 automatisch Band 2 mit umfassen, bzw. dass ein Band 2 Filter in einfacher Weise auch für Band 25 mit ausgelegt werden kann.

In noch weiterer Ausgestaltung kann der Ausgang des Antennenschalters über eine entsprechende Schalterstellung mit einem Triplexer und/oder einem Duplexer und/oder einem Quadplexer verbunden werden. Der Quadplexer kann dabei eine Filterkombination für Band 1 TX oder 65 TX, Band 3 TX, Band 3 RX und Band 32 RX umfassen. Entsprechend ist ein Extraktorband dem RX-Band von Band 4, Band 1 oder Band 65/66 zugeordnet. Der Duplex-Betrieb für Band 1, Band 4 oder Band 66 kann dann über verschiedene Pfade erfolgen, wobei einer der Pfade ein Extraktorpfad ist. Auch diese Ausführung unterstützt Uplink Carrier Aggregation.

Das Frontend-Modul kann in weiteren Ausführungen einen mit einer Diversity-Antenne verbindbaren reinen Empfangspfad umfassen. Weiter ist auch im reinen Empfangspfad eine Extraktor-Anordnung vorgesehen, die einen Extraktorpfad abzweigt. Das entsprechende Extraktorband ist dabei dem RX-Band von Band 4, Band 1 oder Band 66 zugeordnet. Weiterhin ist im reinen Empfangspfad ein Diplexer angeordnet, der den reinen Empfangspfad in zwei reine Empfangsteilpfade teilt, die jeweils einem Mid-Band-und einem High-Band-Bereich zugeordnet sind.

Im Empfangsteilpfad für Mid Band ist dabei ein gemischter Diversity-Diplexer angeordnet, der eine Filterkombination für Band 3 RX/Band 21 RX oder für Band 3 RX/Band 32 RX aufweist. Somit gelingt es auch im reinen Diversity-Empfangspfad, eine Vielzahl unterschiedlicher Empfangsbänder in einfacher Weise zu trennen, wobei der dazu erforderliche Diversity-Diplexer mit relativ hohem Diplexer-Abstand in einfacher Weise realisiert werden kann, ohne dass dadurch die Bändertrennung leidet.

Zwischen der Diversity-Antenne und der Extraktor-Anordnung kann ein weiterer Diplexer, Triplexer oder Quadplexer angeordnet sein, der vom reinen Empfangspfad einen zweiten Teilpfad für den Low-Band-Bereich abzweigt. Somit können bis zu 5 Empfangs-Teilpfade separiert werden, die den Low-Band-, den Mid-Band- den High-Band, den Ultrahighband-und den 5 GHz-Bereich abdecken.

In weiterer Ausgestaltung des Diversity-Pfads wird ein reiner Empfangspfad mit der Diversity-Antenne verbunden. Eine Extraktor-Anordnung zweigt vom reinen Empfangspfad einen Extraktorpfad ab, dessen Extraktorband dem RX-Band von Band 4, Band 1 oder Band 65/66 zugeordnet ist. Weiterhin ist im reinen Empfangspfad ein Diplexer angeordnet, der den reinen Empfangspfad in zwei reine Empfangs-Teilpfade teilt, die jeweils einem Mid-Band- und einem High-Band-Bereich zugeordnet sind. Im Empfangs-Teilpfad für das Mid-Band ist dabei ein gemischter Diversity-Triplexer angeordnet, welcher eine Filterkombination für das RX-Band von Band 32, das RX-Band von Band 21 und das RX-Band von Band 3 aufweist.

Gemäß einer weiteren Ausführungsform sind zwei Extraktor-Anordnungen vorgesehen, die zum Extrahieren von jeweils einem Extraktorband ausgebildet sind. Das erste Extraktorband umfasst dabei Band 30 RX und/oder das Band 40. Das zweite Extraktorband ist für Frequenzen ausgelegt, die aus Galileo, Beidou, Glonass bzw. GPS (GNSS), WLAN 2.4, Band 40, Band 65/66 RX, Band 32 RX und LMB ausgewählt sind. LMB umfasst dabei Frequenzen von 1425 MHz bis 1511 MHz.

Im Folgenden wird die Erfindung anhand von Ausführungsbeispielen und der dazugehörigen Figuren näher erläutert. Die Figuren sind teils schematisch ausgeführt und zeigen in den meisten Fällen nur Teilstrukturen wesentlich umfangreicher Anordnungen bzw. Frontend-Schaltungen.

Es zeigen:
Figur lA ein erstes Frontend-Modul gemäß der Erfindung in schematischer Darstellung,
Figur 1B die in der Anordnung von Figur 1A bestimmten Durchlasskurven zwischen Antennenanschluss und den verschiedenen Teilpfaden,
Figur 2A ein zweites Ausführungsbeispiel eines Frontend-Moduls,
Figur 2B die in der Anordnung von Figur 2A Durchlasskurven zwischen Antennenanschluss und den verschiedenen Teilpfaden,
Figur 3 eine Extraktor-Anordnung, wie sie im erfindungsgemäßen Frontend-Modul Verwendung findet,
Figur 4 verschiedene Anordnungsmöglichkeiten A bis H einer Extraktor-Anordnung in einem erfindungsgemäßen Frontend-Modul,
Figur 5A ein einfaches Ausführungsbeispiel in schematischer Darstellung,
Figur 5B die Durchlasskurven für die zwei Teilpfade und den Extraktionspfad der in Figur 5A dargestellten Anordnung,
Figur 6 eine Tabelle mit Kombinationen von jeweils zwei Bändern, die jeweils mittels unterschiedlicher Extraktor-Anordnungen aus dem Signalpfad eines erfindungsgemäßen Frontend-Moduls extrahierbar sind,
Figur 7 gibt beispielhaft an, wie die beiden Extraktions-Anordnungen auf die verschiedenen Positionen A bis G innerhalb eines Frontend-Moduls gemäß Figur 4 verteilt werden können,
Figur 8 gibt mögliche Durchlassbereiche für zwei in einem erfindungsgemäßen Frontend-Modul einsetzbare Diplexer an,
Figur 9 zeigt mögliche Kombinationen von drei Bändern, die jeweils mittels unterschiedlicher Extraktor-Anordnungen in einem erfindungsgemäßen Modul aus dem Signalpfad extrahiert werden können,
Figur 10A zeigt ein weiteres einfaches Ausführungsbeispiel in schematischer Darstellung,
Figur 10B zeigt die Durchlasskurven für die zwei Teilpfade und den Extraktionspfad der in Figur 10A dargestellten Anordnung,
Figur 11A gibt an, wie drei im erfindungsgemäßen Frontend-Modul einsetzbare Extraktor-Anordnungen über die verschiedenen Extraktor-Anordnungspositionen gemäß Figur 4 verteilt werden können,
Figur 11B zeigt weitere Positioniermöglichkeiten für eine Kombination von drei Extraktor-Anordnungen in einem Fronend-Modul,
Figur 11C zeigt das Ausführungsbeispiel eines neuartigen Hexaplexer die Durchlasskurven zwischen Antennenanschluss und den verschiedenen Teilpfaden,
Figur 12 zeigt eine Extraktor-Anordnung mit einem schaltbaren Überbrückungspfad,
Figur 13 zeigt ein Ausführungsbeispiel mit neuartigen Duplexer-Kombinationen,
Figur 14 zeigt ein Ausführungsbeispiel mit einem gemischten Duplexer und zwei gemischten Triplexern,
Figur 15A zeigt ein weiteres Ausführungsbeispiel mit gemischten Duplexern und Triplexern,
Figur 15B zeigt ein weiteres Ausführungsbeispiel, das sich am ersten Antennenschalter von Figur 15A unterscheidet,
Figur 15C zeigt ein weiteres Ausführungsbeispiel, das sich ebenfalls nur am ersten Antennenschalter von Figur 15A unterscheidet,
Figur 16 zeigt ein weiteres Ausführungsbeispiel mit zwei gemischten Triplexern,
Figur 17 zeigt ein weiteres Ausführungsbeispiel mit einem gemischten Triplexer und einem gemischten Quadplexer,
Figur 18A zeigt ein erfindungsgemäßes Ausführungsbeispiel für ein an eine Diversity- Antenne anschließbares Frontend-Modul mit einem gemischten Diversity-Diplexer,
Figur 18B zeigt ein erfindungsgemäßes Ausführungsbeispiel für ein an eine Diversity-Antenne anschließbares Frontend-Modul mit zwei gemischten Diversity-Diplexer,
Figur 19 zeigt ein weiteres erfindungsgemäßes Frontend-Modul, das an eine Diversity-Antenne anschließbar ist und an einem Antennenschalter einen gemischten Diversity-Triplexer aufweist,
Figur 20 zeigt mögliche Kombinationen, die mit zwei Extraktor-Anordnungen in einem erfindungsgemäßen Frontend-Modul realisiert sein können, wobei zumindest eine Extraktor-Anordnung für Band 30 (Tx und Rx) und/oder Band 40 ausgelegt ist,
Figur 21 zeigt eine mögliche Kombination von zwei Extraktor-Anordnungen und deren Anordnung in einem erfindungsgemäßen Frontend-Modul,
Figur 22 zeigt verschiedene Möglichkeiten, drei Extraktor-Anordnungen in einem erfindungsgemäßen Frontend-Modul anzuordnen,
Figur 23 zeigt verschiedene Möglichkeiten, die Frequenzen der Durchlassbänder für zwei in einem erfindungsgemäßen Frontend-Modul einsetzbare Diplexer einzustellen,
Figur 24 zeigt, wie drei unterschiedliche Extraktor-Anordnungen in einem Frontend-Modul positioniert werden können,
Figur 25 zeigt ein erfindungsgemäßes Frontend-Modul mit zwei gemischten Triplexem und einem gemischten Duplexer an einem Antennenschalter in Kombination mit einer zweiten Antenne,
Figur 26 zeigt eine weitere Variation eines Frontend-Moduls mit zwei Antennen und gemischten Triplexern an einem Antennenschalter,
Figur 27 zeigt ein Frontend-Modul mit zwei Extraktor-Anordnungen und zwei gemischten Duplexern an einem Antennenschalter,
Figur 28 zeigt ein weiteres Frontend-Modul mit zwei Extraktor-Anordnungen, die gegenüber der Ausführung nach Figur 27 eine geänderte Positionierung aufweisen, sowie zwei gemischte Duplexer an einem Antennenschalter.

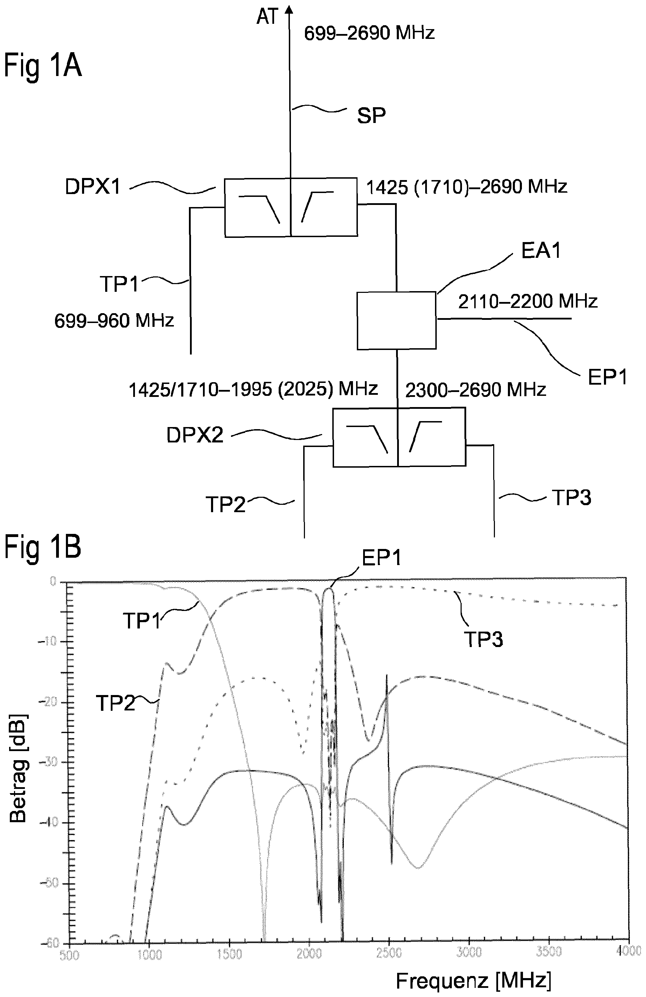

Figur 1A zeigt ein einfaches erfindungsgemäßes Frontend-Modul, welches mittels zweier Diplexer DPX1, DPX2 drei Teilpfade TP1 bis TP3 voneinander trennen kann, die jeweils einem Frequenz-Teilbereich zugeordnet sind. Ein weiteres Frequenzband, welches zwischen zweien der Frequenz-Teilbereiche angeordnet ist, wird mittels einer Extraktor-Anordnung EA1 aus dem Signalpfad SP extrahiert.

Ein erster Diplexer DPX1 ist mit einem Antennenanschluss AT über einen Signalpfad SP verbunden. Der Antennenanschluss AT ist mit einer Antenne verbindbar und vermag ein HF-Signal zwischen 699 MHz und 2690 MHz zu übertragen. Der erste Diplexer DPX1 umfasst einen Tiefpass und einen Hochpass, die jeweils einen Frequenz-Teilbereich einem Teilpfad TP am Ausgang des Diplexers DPX zuweisen. Am Ausgang des Tiefpasses beginnt der erste Teilpfad TP1, der beispielsweise für einen Low Band Bereich mit Frequenzen zwischen 699 MHz und 960 MHz ausgelegt ist. Am Ausgang des Hochpasses dagegen können Frequenzen von 1425 MHz bis 2690 MHz bzw. 1710 MHz bis 2690 MHz übertragen werden.

Eine erste Extraktor-Anordnung EA1 ist mit dem ersten Diplexer DPX1 verbindbar im Signalpfad SP angeordnet. Die Extraktor-Anordnung EA1 kann zwischen Antennenanschluss AT und erstem Diplexer oder im Signalpfad am Ausgang des ersten Diplexers angeordnet sein.

Die erste Extraktor-Anordnung ist für ein Extraktorband ausgelegt, welches für die RX-Bänder von Band 1, Band 4 und/oder Band 65/66 durchlässig ist. Diese Frequenzen werden über einen Extraktionspfad EP1 aus dem Signalpfad extrahiert. Das in der Extraktor-Anordnung EA1 enthaltene Notch-Filter weist einen Sperrbereich auf, sodass Frequenzen innerhalb des Sperrbereichs den Signalpfad nicht passieren können, sondern über den Extraktionspfad EP1 und das darin angeordnete Bandpassfilter in einem separaten Pfad, eben dem genannten Extraktionspfad EP1,ausgeleitet bzw. aus dem Signalpfad SP extrahiert werden.

Hinter der Extraktionsanordnung EA1 ist ein zweiter Diplexer DPX2 im Signalpfad angeordnet, mit dem der verbliebene Frequenzbereich weiter aufgeteilt wird in ein Mid-Band, welches einen Frequenzbereich zwischen 1425 MHz und 2025 MHz oder alternativ zwischen 1710 MHz und 2025 MHz umfasst, sowie einen High-Band-Bereich, welcher Frequenzen von 2300 MHz bis 2690 MHz umfasst. Signale mit Frequenzen im Mid-Band und im High-Band werden am Ausgang des Diplexers entsprechend einem zweiten Teilpfad TP2 bzw. einem dritten Teilpfad TP3 zugewiesen.

Indem ein Bereich zwischen 2110 MHz und 2200 MHz über den Extraktionspfad EP1 aus dem Signalpfad ausgefiltert wird, kann der zweite Diplexer DPX2 mit einem größeren Diplexerabstand ausgebildet werden, welches mit technisch einfacheren Maßnahmen möglich ist. So ist es ausreichend, den Diplexerabstand auf den Frequenzbereich zwischen der Obergrenze des Tiefpasses bei 2025 MHz und dem Beginn des High-Bands, entsprechend der Untergrenze des Passes bei 2300 MHz zu positionieren, was einem Diplexerabstand von 275 MHz entspricht. Ohne die Extraktor-Anordnung EA1 wäre ein Diplexer zur Trennung von Mid-Band und High-Band erforderlich, dessen Diplexerabstand zwischen 2200 MHz und 2300 MHz, mithin auf einen Wert von nur 100 MHz einzustellen ist. Mit der Extraktor-Anordnung wird die technische Ausführung des Diplexers stark erleichtert und es ist sogar ein integrierter Diplexer in LTCC oder Laminat realisierbar. Natürlich kann der Diplexer auch als diskretes Filter aus SMD-Induktivitäten und SMD-Kapazitäten ausgebildet werden.

Sofern der zweite Frequenzbereich, der am Ausgang des Tiefpasses des zweiten Diplexers DPX2 dem zweiten Teilpfad TP2 zugewiesen ist, Band 34 Frequenzen nicht umfassen muss, kann die Obergrenze des Tiefpasses weiter auf einen Wert von 1995 MHz abgesenkt werden, wodurch sich der Diplexerabstand auf mögliche 305 MHz erhöht.

Mit dem dargestellten Frontend-Modul können also drei Frequenzbereiche und ein Extraktionsband sauber separiert werden und unabhängig voneinander parallel betrieben werden. Dies kann mit Diplexern erreicht werden, die einen leicht realisierbaren hohen Diplexerabstand von zumindest 275 MHz, bis 305 MHz für den zweiten Diplexer sowie von 465 MHz bis 750 MHz für den ersten Diplexer DPX1 aufweisen.

Figur 1B zeigt vier Durchlasskurven, die zwischen dem Antennenanschluss AT und dem Ausgang für den ersten Teilpfad TP1 am Tiefpassausgang des ersten Diplexers DPX1, zwischen dem Antennenanschluss AT und dem Tiefpassausgang des zweiten Diplexers DPX2 sowie zwischen dem Antennenanschluss AT und dem Ausgang des Hochpasses des zweiten Diplexers DPX2 bestimmt sind.

Es zeigt sich, dass im ersten Teilpfad TP1 Frequenzen des Low Bands mit geringer Einfügedämpfung erhalten werden, wobei der Sperrbereich mit hoher Dämpfung sauber separiert ist. Im zweiten Teilpfad TP2 werden Signale im Mid-Band-Bereich, hier zwischen 1710 MHz und 1990 MHz, übertragen. Da die Extraktor-Anordnung EA1 das Passieren von Frequenzen im Sperrbereich des Notch-Filters der Extraktor-Anordnung verhindert und der Sperrbereich an der Oberkante des Tiefpassfilters angeordnet ist, fällt dadurch die rechte Flanke der Durchlasskurve für das Mid Band steil ab, was für eine gute Trennung der Frequenzteilbereiche vorteilhaft ist.

Die am Extraktorpfad EP1 extrahierten Frequenzen haben das Bandpassfilter der Extraktor-Anordnung passiert und weisen ebenfalls ein Passband mit steil abfallenden Flanken auf.

Auch die linke Flanke des dem dritten Teilpfad TP3 zugewiesenen High Bands weist einen steilen Anstieg auf und ist daher sauber gegen das dem zweiten Teilpfad TP2 zugeordnete Mid Band separiert.

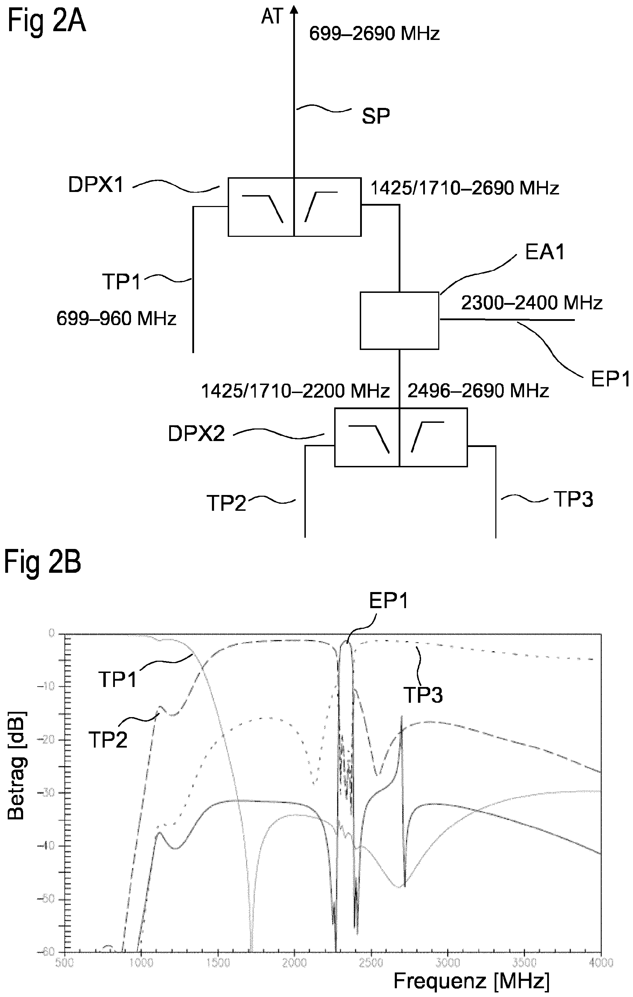

Figur 2A zeigt ein weiteres Frontend-Modul, welches vom Prinzip wie das in Figur 1A dargestellte Frontend-Modul ausgebildet ist. Der erste Diplexer, der mit dem Antennenanschluss AT verbindbar ist, ist auf die gleichen Frequenzbereiche ausgelegt wie der von Figur 1A. Mit dem Ausgang des Hochpasses des ersten Diplexers verbunden ist eine erste Extraktor-Anordnung EA1, die in dieser Ausführung zur Extraktion von Frequenzen im Bereich von Band 30 und/oder Band 40 ausgelegt ist. Im ersten Extraktionspfad EP1 können somit Frequenzen zwischen 2300 MHz und 2400 MHz extrahiert werden. Entsprechend ist der Sperrbereich der Extraktor-Anordnung EA1 so ausgelegt, dass er zumindest die Frequenzen des Extraktionspfads EP1 umfasst.

Hinter der ersten Extraktor-Anordnung EA1 ist ein zweiter Diplexer DPX2 vorgesehen, dessen Durchlassbereiche beiderseits des Sperrbereichs der ersten Extraktor-Anordnung EA1 positioniert sind. Entsprechend wird am Ausgang des Tiefpasses des zweiten Diplexers DPX2 im zweiten Teilpfad TP2 ein Frequenzbereich zwischen 1425 MHz und 2200 MHz übertragen, während dem dritten Teilpfad TP3 am Ausgang des Hochpasses Frequenzen von 2496 MHz bis 2690 MHz zugewiesen werden.

Auch hier ist der Abstand zwischen dem Mid Band des zweiten Teilpfads TP2 und dem High Band, welches dem dritten Teilpfad TP3 zugewiesen ist, auf einen Wert von 296 MHz erhöht, da die an der Untergrenze des High-Band-Bereichs liegenden Frequenzen des ersten Extraktionspfads EP1 nicht mehr über den zweiten Diplexer DPX2 dem dritten Teilpfad TP3 zugewiesen werden müssen. Mit Hilfe der ersten Extraktor-Anordnung wird also der Diplexerabstand von 100 MHz auf 296 MHz erhöht. Dies ermöglicht es auch hier, den Diplexer mit einfacher Technologie ein LTCC-Substrat oder ein Laminat zu integrieren. Natürlich ist es auch möglich, den Diplexer aus SMD-Induktivitäten und SMD-Kapazitäten zu realisieren.

Figur 2B zeigt Durchlasskurven, die bei der Anordnung nach Figur 2A zwischen dem Antennenanschluss AT und dem jeweiligen Teilpfad TP1, TP2 und TP3 gemessen sind bzw. Signale, die vom Antennenanschluss AT in den ersten Extraktionspfad EP1 gelangen können. Auch hier zeigt sich, dass das gegenüber den anderen Frequenzteilbereichen fernab gelegene Low Band entsprechend dem ersten Teilpfad TP1 mit hoher Dämpfung gegen höher liegende Frequenzteilbereiche getrennt ist. Die Kurve für den Mid-Band-Bereich, der dem zweiten Teilpfad TP2 am Ausgang des Tiefpasses des zweiten Diplexers zugewiesen ist, fällt an der rechten Flanke steil ab.

Die linke Flanke des High-Band-Bereichs, der dem dritten Teilpfad TP3 zugewiesen ist, steigt stark an. Genau zwischen High-Band- und Low-Band-Bereich, die den Frequenzteilbereichen des zweiten Diplexers entsprechen, liegen die Frequenzen, die in den ersten Extraktionspfad EP1 gelangen können, und sind so sauber gegen die anderen Bänder bzw. Frequenzbereiche isoliert. An den kritischen Grenzen zwischen den Frequenzen des dritten Teilpfads und dem Extraktionspfad sowie zwischen den Frequenzen des zweiten Teilpfads und dem Extraktionspfad sind die Durchlasskurven steil abfallend. Somit gelingt auch hier eine saubere Trennung dreier Frequenzteilbereiche, die wiederum sauber gegen Frequenzen des ersten Extraktionspfads EP1 separiert sind.

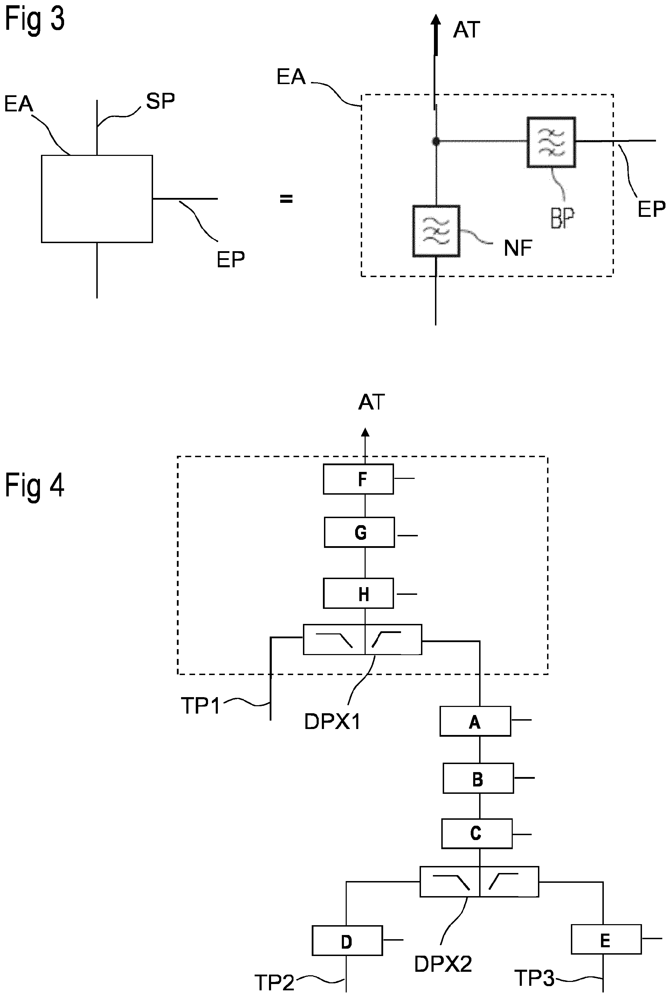

Figur 3 zeigt in schematischer Darstellung einen möglichen Aufbau einer erfindungsgemäß eingesetzten Extraktor-Anordnung. Eine solche Extraktor-Anordnung ist im Prinzip aus der europäischen Patentanmeldung EP 1,683,275A bekannt. Die Extraktor-Anordnung EA kann in einen beliebigen Signalpfad SP eingebunden werden und zweigt von diesem dann einen Extraktionspfad EP ab. Dabei dient ein im Signalpfad SP angeordnetes Notch-Filter NF dazu, Frequenzen des Sperrbereichs mit hoher Effektivität zu reflektieren, sodass sie das Notch-Filter NF nicht passieren können. Signale mit Frequenzen im Sperrbereich werden vielmehr in einen Extraktionspfad EP geleitet, der an einen Knoten zwischen Antennenanschluss und Notch-Filter NF angebunden ist.

Ein im Extraktionspfad EP angeordnetes Bandpassfilter BP dient zur weiteren Filterung der im Sperrbereich liegenden Frequenzen, sodass im weiteren Extraktionspfad EP ein schmales Frequenzband mit sauberen Flanken extrahiert werden kann. Vorzugsweise können mit der Extraktor-Anordnung schwache RX-Signale aus dem Signalpfad extrahiert werden.

Die Erfindung nutzt die Extraktor-Anordnung jedoch zusätzlich dazu, über den Sperrbereich des Notch-Filters den Abstand zwischen den benachbarten in Teilpfade zu separierenden Frequenzbereichen zu vergrößern und somit die Realisierung der zur Trennung der Frequenzbereiche erforderlichen Diplexer zu erleichtern.

Figur 4 zeigt anhand einer stark schematisierten Darstellung ein Frontend-Modul mit einem ersten Diplexer DPX1 und einem in Serie geschalteten zweiten Diplexer DPX2. Damit können im Frontend-Modul drei Teilpfade TP1, TP2 und TP3 voneinander getrennt werden. Die Nummerierung der Teilpfade erfolgt individuell für jedes Ausführungsbeispiel und kann in einem anderen Ausführungsbeispiel davon abweichen. Entsprechend können auch die Frequenzbereiche, die einem bestimmten Teilpfad bzw. einem Teilpfad mit einer bestimmten Nummerierung zugewiesen sind, differieren.

Zwischen Antennenanschluss AT und den verschiedenen Teilpfaden TP1 bis TP3 können nun unterschiedliche Positionierungen für Extraktor-Anordnungen vorgesehen werden. So können zwischen Antennenanschluss und erstem Diplexer beispielsweise bis zu drei Extraktor-Anordnungen an den Positionen F, G und H vorgesehen werden. Zwischen dem ersten Diplexer DPX1 und dem zweiten Diplexer DPX2 können unabhängig davon bis zu drei Extraktor-Anordnungen an den Positionen A, B und C vorgesehen werden. Die unterschiedlichen Extraktor-Anordnungen dienen zur Extraktion unterschiedlicher Extraktorbänder. Vorzugsweise umfasst die erste der drei Extraktoranordnungen das Band 30 und/oder B40.

Weitere Extraktor-Anordnungen können mit dem Ausgang des zweiten Diplexers DPX2 verbunden werden, beispielsweise an der Position D am Ausgang des Tiefpasses des zweiten Diplexers bzw. an der Position E am Ausgang des Hochpasses des zweiten Diplexers DPX2. Durch die unterschiedlichen Möglichkeiten der Positionierung einer oder mehrerer Extraktor-Anordnungen können die Durchlassbereiche der Diplexer unterschiedlich kombiniert werden und unterschiedliche Bänder je nach Bedarf ausgefiltert bzw. separiert werden.

Die mit einer strichlierten Linie umgrenzte Teilstruktur ist optional. D.h., auch ein Frontendmodul ohne den ersten Diplexer DPX1 und die möglicherweise vorgeschalteten Extraktoranordnungen wird als erfindungsgemäß angesehen.

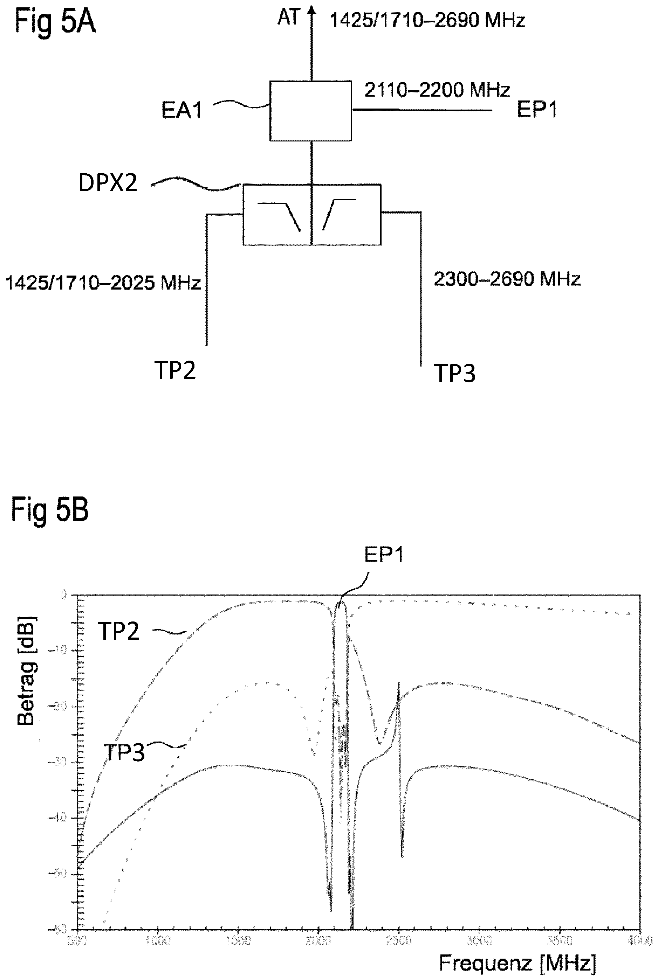

Figur 5A zeigt ausschnittsweise eine Anordnung, die Teil eines erfindungsgemäßen Frontend-Moduls ist. Hier ist eine erste Extraktor-Anordnung EA1 zwischen einem Antennenanschluss AT und einem ersten Diplexer DPX2 angeordnet. Dies schließt nicht aus, dass weitere Elemente zwischen Antennenanschluss und erster Extraktor-Anordnung bzw. zwischen erstem Diplexer und dem Sende-Empfangsteil des Frontend-Moduls bzw. der Mobilfunkeinrichtung angeordnet sind.

In diesem Ausführungsbeispiel werden über den Antennenanschluss AT Signale zwischen 1425 MHz und 2690 MHz bzw. zwischen 1710 MHz und 2690 MHz transportiert, je nachdem, ob Frequenzen von 1559 MHz bis 1605 MHz für Galileo, Beidou, Glonass bzw. GPS (GNSS) oder die Bänder 11, 21 und 32 transportiert bzw. ausgefiltert werden sollen.

Ein Filter für Band 32 Rx umfasst automatisch Band 11 Rx, während sich das schmale Band 21 Rx direkt oberhalb an Band 11 anschließt, so dass entsprechend breitere Filter auch Band 21 Rx mit umfassen können, was daher stets eine Option darstellt. Die erste Extraktor-Anordnung EA1 weist dem Extraktionspfad ein Extraktionsband zwischen 2110 MHz und 2200 MHz zu. Entsprechend ist das Bandpassfilter im ersten Extraktionspfad EP1 für diesen Frequenzbereich ausgelegt und weist ein entsprechendes Passband auf.

Der Sperrbereich der ersten Extraktor-Anordnung EA1 ermöglicht es, den ersten Diplexer DPX2 so zu konfigurieren, dass die rechte Flanke des Tiefpasses bei 2025 MHz endet. Entsprechend beginnt der Hochpass bei 2300 MHz zu übertragen und kann einen Frequenzbereich bis 2690 MHz dem zweiten Teilpfad TP2 zuweisen. Das dem ersten Extraktionspfad EP1 zugewiesene Extraktorband umfasst die RX-Bänder von Band 1, Band 4 und Band 65/66, die allesamt zwischen 2110 MHz und 2200 MHz liegen.

Figur 5B zeigt die Übertragungskurven für Signale, die zwischen Antennenanschluss AT und erstem Teilpfad TP1, zwischen Antennenanschluss AT und zweitem Teilpfad TP2 bzw. zwischen Antennenanschluss AT und Extraktionspfad EP1 in einer Anordnung nach Figur 5A übertragen werden können. Auch hier zeigt sich wieder die gute Separierung zwischen dem ersten Teilpfad TP2 für Low und Mid Band gegenüber dem im zweiten Teilpfad TP3 übertragenem High Band. Völlig separiert davon ist das Extraktorband, das im ersten Extraktionspfad EP1 extrahiert werden kann. Die Übertragungskurve für das Extraktorband weist aufgrund des Bandpassfilters der Extraktor-Anordnung eine Bandpasscharakteristik auf.

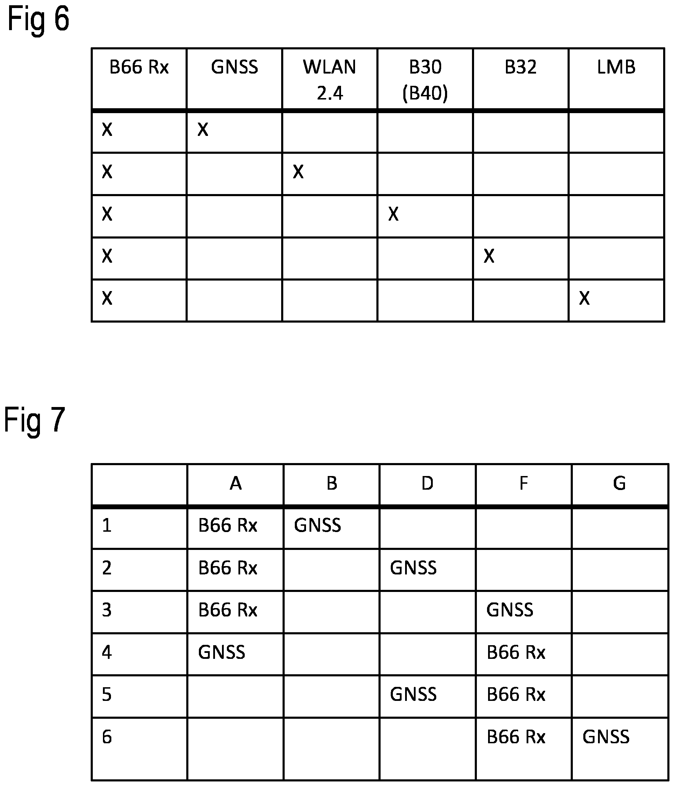

Figur 6 zeigt eine Tabelle, welche Frequenzbereiche bzw. Bänder mittels Extraktor-Anordnungen in einfacher Weise aus dem Signalpfad separiert werden können. Dargestellt sind Zweierkombinationen von Bändern, die zusammen in einem Frontend-Modul mit den Extraktor-Anordnungen extrahiert werden können. Eine der Extraktor-Anordnungen deckt dabei den Frequenzbereich von 2110 MHz bis 2200 MHz ab. Darin liegen die RX-Bänder von Band 1, 4 und 66. Die zweite Extraktor-Anordnung kann einen Frequenzbereich für Glonass (GNSS), WLAN 2.4, Frequenzen von Band 30 und/oder Band 40, RX-Frequenzen von Band 32 oder das lower Mid Band LMB abdecken, welches Frequenzen von 1425 MHz bis 1511 MHz umfasst.

Figur 7 zeigt eine Tabelle, die angibt, wie zwei beispielhafte Extraktor-Anordnungen, hier für die RX-Frequenzen von Band 1/4/65/66 und für Frequenzen von 1559 MHz bis 1605 MHz (GNSS), auf die verschiedenen möglichen Positionen im Frontendmodul von Figur 4 verteilt werden können. Es wird gezeigt, dass die Extraktor-Anordnung zwischen Antennenanschluss und erstem Diplexer an den Positionen F und G sowie zwischen erstem Diplexer und zweitem Diplexer an den Positionen A und B sowie am Ausgang des Tiefpasses des zweiten Diplexers DPX2 an der Position D angeordnet werden können.

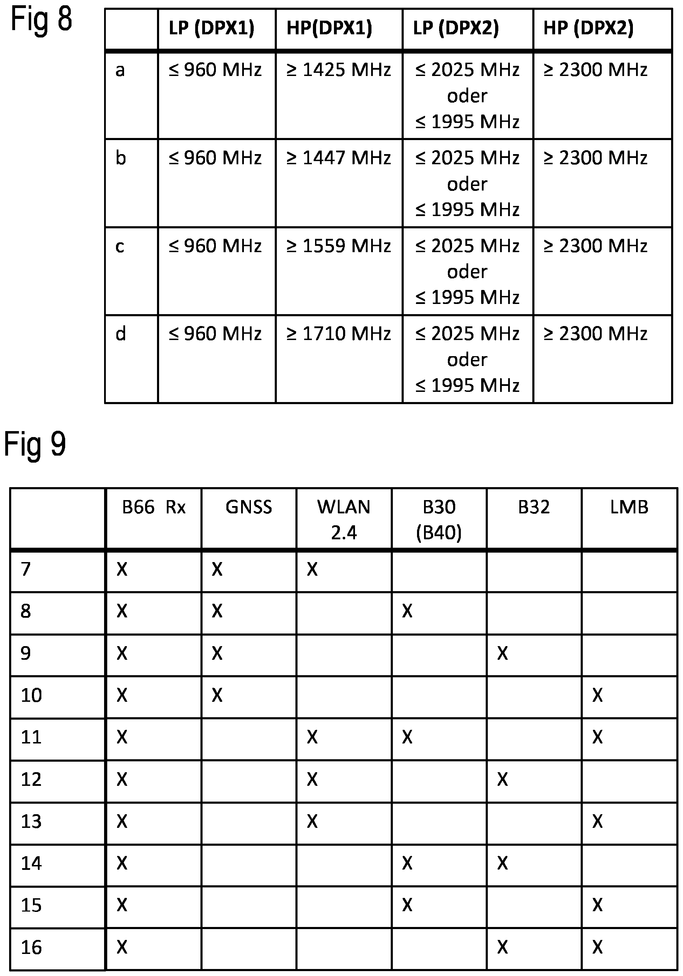

Figur 8 gibt vier mögliche Konfigurationen für die Durchlassbereiche von erstem und zweiten Diplexer DPX1 und DPX2 an, wie sie für ausgewählte Extraktorkombinationen gemäß den Figuren 6 und 7 in einem schematisch in Figur 4 dargestellten Frontend-Modul eingesetzt werden können. Für alle vier Varianten a, b, c und d endet das Low Band am Tiefpass LP des ersten Diplexers DPX1 bei 960 MHz. Das am Hochpassausgang des ersten Diplexers anliegende Signal beginnt im Fall a bei 1425 MHz, im Fall b bei 1450 MHz, im Fall c bei 1559 MHz und im Fall d bei 1710 MHz. Der Tiefpass LP des zweiten Diplexers endet in allen Fällen a bis d bei einer Obergrenze von 1995 MHz oder bei 2025 MHz. Den Hochpass HP des zweiten Diplexers DPX2 können Signale mit Frequenzen > 2300 MHz in allen 4 Diplexer Konstellationen a bis d passieren.

Figur 9 zeigt mögliche Kombinationen, wie in einem erfindungsgemäßen Frontend-Modul drei unterschiedliche Extraktor-Anordnungen für drei unterschiedliche Bänder an verschiedenen Positionen positioniert werden können. Eine der Extraktor-Anordnungen dient zur Extraktion der Rx Frequenzen von Band 66. Mit weiteren Extraktor-Anordnungen werden zwei weitere Bänder extrahiert, die unabhängig voneinander ausgewählt sind aus GNSS, WLAN 2.4, Band 30/Band 40, Band 32 und LMB. Für die Auswahl von zwei zusätzlichen Bändern ergeben sich zehn unterschiedliche Möglichkeiten.

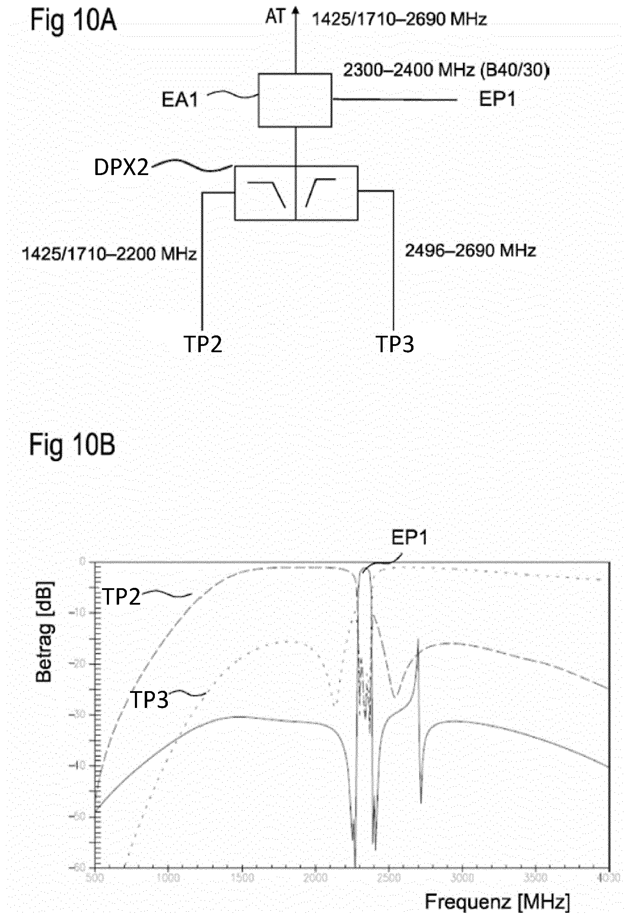

Figur 10A zeigt ausschnittsweise eine Anordnung, die Teil eines erfindungsgemäßen Frontend-Moduls ist. Hier ist ähnlich wie in Figur 5A eine erste Extraktor-Anordnung EA1 zwischen einem Antennenanschluss AT und einem ersten Diplexer DPX2 angeordnet. Dies schließt nicht aus, dass weitere Elemente zwischen Antennenanschluss und erster Extraktor-Anordnung bzw. zwischen erstem Diplexer und dem Sende-Empfangsteil des Frontend-Moduls bzw. der Mobilfunkeinrichtung angeordnet sind.

In diesem Ausführungsbeispiel werden über den Antennenanschluss AT Signale zwischen 1425 MHz und 2690 MHz bzw. zwischen 1425 MHz (1710 MHz) und 2690 MHz transportiert, je nachdem, ob Frequenzen für Galileo, Beidou, Glonass bzw. GPS (GNSS) oder zumindest eines der Bänder 11, 21 und 32 transportiert bzw. ausgefiltert werden sollen. Die erste Extraktor-Anordnung EA1 weist dem Extraktionspfad ein Extraktionsband zwischen 2300 MHz und 2400 MHz zu. Entsprechend ist das Bandpassfilter im ersten Extraktionspfad EP1 für diesen Frequenzbereich ausgelegt und weist ein entsprechendes Passband auf.

Der Sperrbereich der ersten Extraktor-Anordnung EA1 ermöglicht es, den ersten Diplexer DPX2 so zu konfigurieren, dass die rechte Flanke des Tiefpasses bei 2200 MHz endet. Entsprechend beginnt der Hochpass bei 2496 MHz zu übertragen und kann einen Frequenzbereich bis 2690 MHz dem zweiten Teilpfad TP3 zuweisen. Das dem ersten Extraktionspfad EP1 zugewiesene Extraktorband umfasst die Frequenzen von Band 30 und/oder Band 40, die beide zwischen 2300 MHz und 2400 MHz liegen.

Figur 10B zeigt die Übertragungskurven für Signale, die zwischen Antennenanschluss AT und erstem Teilpfad TP2, zwischen Antennenanschluss AT und zweitem Teilpfad TP3 bzw. zwischen Antennenanschluss AT und Extraktionspfad EP1 in einer Anordnung nach Figur 5A übertragen werden können. Auch hier zeigt sich wieder die gute Separierung zwischen dem ersten Teilpfad TP2 für Low und Mid Band gegenüber dem im zweiten Teilpfad TP3 übertragenem High Band. Völlig separiert davon ist das Extraktorband, das im ersten Extraktionspfad EP1 extrahiert werden kann. Die Übertragungskurve für das Extraktorband weist aufgrund des Bandpassfilters der Extraktor-Anordnung eine Bandpasscharakteristik auf.

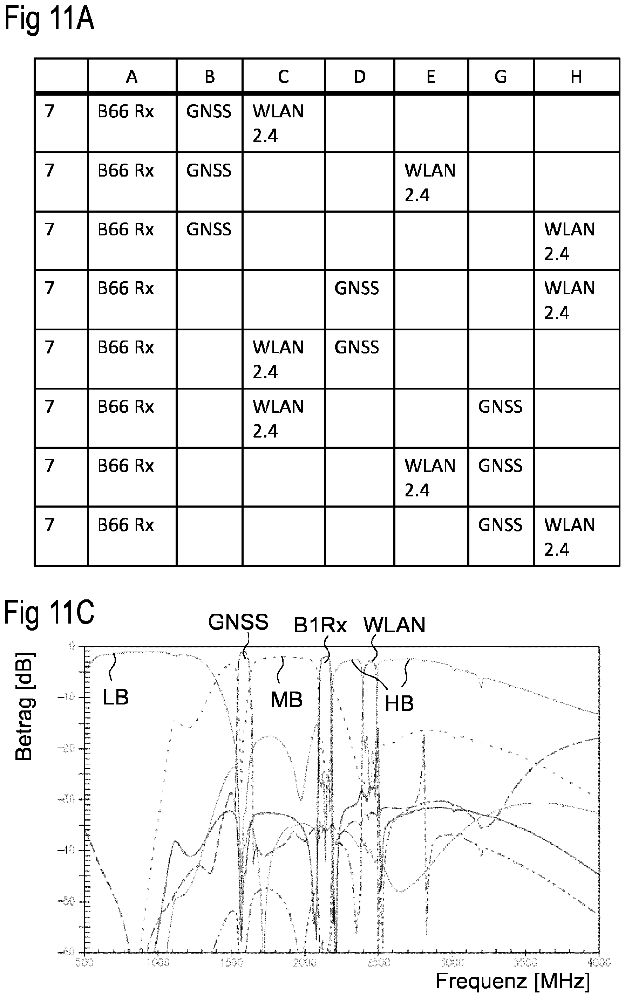

Figur 11A zeigt anhand einer Tabelle acht verschiedene Möglichkeiten, die drei Extraktor-Anordnungen für die beispielhafte Drei-Bänder-Kombination Nr. 7 gemäß Figur 9 in einem Frontend-Modul, wie es in Figur 4 schematisch dargestellt ist, anzuordnen. Allen acht unterschiedlichen Anordnungen ist gemeinsam, dass die immer vorhandene Extraktor-Anordnung für das Rx Band 65/66 auf der Position A verbleibt, die zwischen erstem und zweitem Diplexer liegt.

Auch für diese Verteilung der Extraktor-Anordnungen über das Frontend-Modul werden die Diplexer, wie in Figur 8 angegeben, konfiguriert

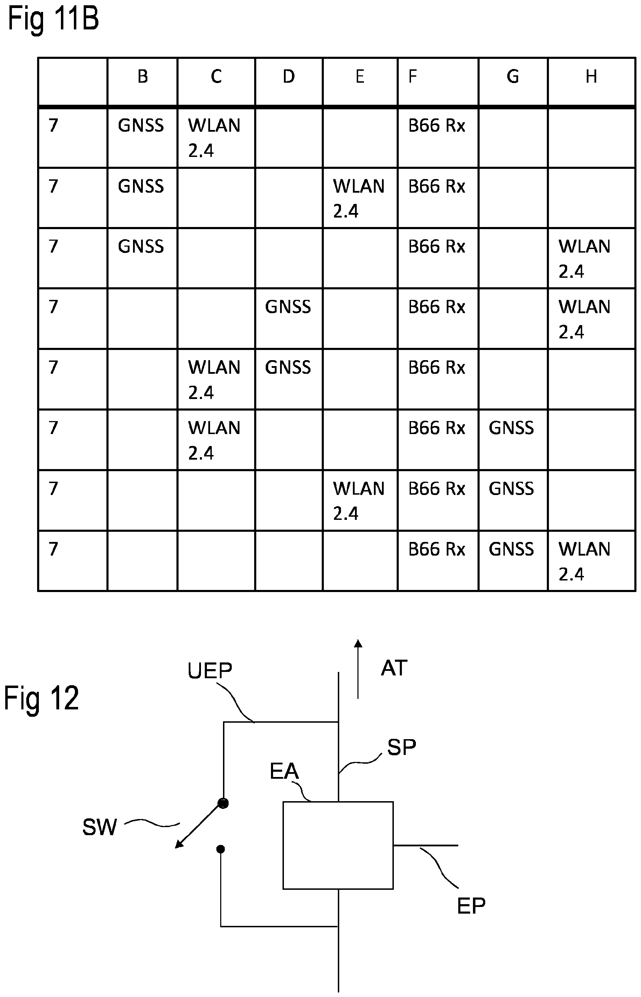

Figur 11B zeigt anhand einer Tabelle acht weitere Anordnungsmöglichkeiten für die Kombination von drei Extraktor-Anordnungen gemäß der Kombination Nr. 7. Allen diesen acht Varianten ist gemeinsam, dass die Extraktor-Anordnung für Band 66 Rx der Position F zugewiesen wird, das bedeutet zwischen Antennenanschluss AT und erstem Duplexer DPX2.

Auch für diese Positionierungen der Extraktor-Anordnungen werden die Diplexer wie in Figur 8 angegeben konfiguriert.

Figur 11C zeigt anhand simulierter Durchlasskurven, wie in einem Frontendmodul mit Hilfe von drei Extraktor-Anordnungen für GNSS, Band 1 Rx und WLAN 2.4, die z.B. zwischen zwei Diplexern angeordnet sein können, ein Hexaplexer erhalten werden kann, der sechs verschiedene Frequenzbereiche sauber voneinander trennt:
1. Einen Lowband zwischen 699 und 960 MHz
2. GNSS um 1575 MHz
3. das Rx Band von Band 66 (Band 1)
4. einen Midband Bereich MB zwischen 1710 MHz (bzw. 1425 MHz) und 1990 MHz
5. WLAN 2.4 MHz
6. einen Highband Bereich HB zwischen 2300 MHz und 2380 MHz bzw. zwischen 2510 MHz und 2690 MHz

Auch hier ist die Anforderung an den Diplexer, der Midband MB und Highband HB voneinander trennt, vereinfacht, indem der Diplexerabstand vergrößert und zwischen 1995 MHz (bzw. 2025 MHz) und 2300 MHz eingestellt werden kann.

Figur 12 zeigt eine Möglichkeit, ein Frontend-Modul mit einer beliebigen Anzahl von Extraktor-Anordnungen zu versehen, ohne dabei unnötige Verluste in Kauf nehmen zu müssen, wenn für einen Betriebsmodus eine oder mehrere Extraktor-Anordnungen nicht benötigt werden. Dazu wird ein Überbrückungspfad UEP vorgesehen, der einen Knoten in der Signalleitung vor der Extraktor-Anordnung mit einem Knoten hinter der Extraktor-Anordnung kurzschließt und so das Notchfilter überbrückt. Im Überbrückungspfad UEP ist ein Schalter SW angeordnet, der den Überbrückungspfad aktivieren oder deaktivieren kann. Bei geschlossenem Schalter SW ist dann die Extraktor-Anordnung inaktiv, während sie bei geöffnetem Schalter SW aktiv ist und das entsprechende Extraktorband über den Extraktionspfad EP extrahiert. In allen Ausführungsbeispielen können daher die Extraktoranordnungen optional mit einem solchen Überbrückungspfad UEP überbrückt werden, auch wenn dies in den entsprechenden Figuren nicht dargestellt ist.

Auf diese Weise ist es möglich, genau die Extraktor-Anordnung aktiv zu schalten, die für den jeweiligen Betriebsmodus benötigt wird, insbesondere für den speziellen Carrier Aggregation Mode.

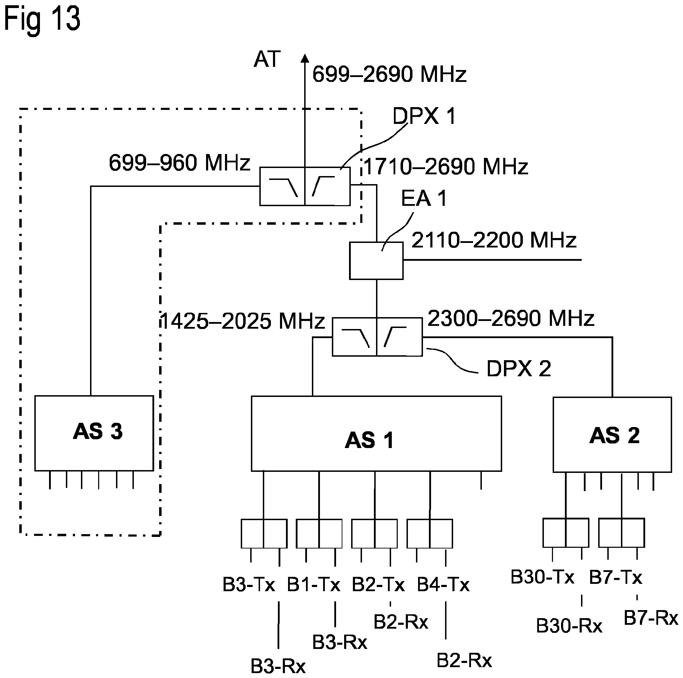

Figur 13 zeigt anhand eines schematischen Blockschaltbilds ein Frontend-Modul gemäß einem weiteren Ausführungsbeispiel der Erfindung. In diesem Modul ist ein Antennenanschluss AT mit einem ersten Diplexer DPX1 verbunden. Die Antenne ist zumindest für Frequenzen von 699 MHz bis 2690 MHz ausgelegt. Der erste Diplexer umfasst eine Hochpass-Tiefpass-Kombination, wobei der Tiefpass einen Frequenzbereich von 699 MHz bis 960 MHz abtrennt. Der Hochpass trennt Frequenzen von 1710 MHz bis 2690 MHz ab und weist sie einem zweiten Teilpfad zu. In diesem zweiten Teilpfad ist eine erste Extraktor-Anordnung EA1 eingefügt, die zur Extraktion von Band 65/66 Rx bzw. von Frequenzen zwischen 2110 und 2200 MHz ausgelegt ist. Die Extraktor-Anordnung EA1 kann mit einem Überbrückungspfad wie in Figur 12 versehen sein (nicht dargestellt).

Weiter folgt im zweiten Teilpfad hinter der Extraktor-Anordnung EA1 ein zweiter Diplexer DPX2, der wiederum eine Hochpass-Tiefpass-Kombination zur Trennung zweier Frequenz-Teilbereiche umfasst. Der Tiefpass trennt dabei Signale von 1425 MHz bis 2025 MHz ab und weist diese einem ersten Antennenschalter AS1 zu. Am Ausgang des Hochpasses werden Frequenzen von 2300 MHz bis 2690 MHz ausgeleitet und einem zweiten Antennenschalter AS2 zugeleitet.

Der Ausgang des Tiefpasses am ersten Diplexer DPX1 wird mit einem dritten Antennenschalter AS3 verbunden, welcher diese Signale in die verschiedenen Bänder des Low-Band-Bereichs separiert.

Die Gesamtanordnung kann als ein Quadplexer betrachtet werden, welcher Signale aus vier verschiedenen Bandbereichen unabhängig voneinander separieren kann, nämlich dem Low-Band-Bereich, dem Mid-Band-Bereich und dem High-Band-Bereich, wobei ein vierter Bereich als einzelnes Band über die Extraktor-Anordnung separiert wird.

In einer Variante dieses Frontend-Moduls kann auf den ersten Diplexer DPX1 verzichtet werden, sodass der Antennenanschluss AT direkt mit der ersten Extraktor-Anordnung EA1 verbunden ist. Die verbleibenden Einheiten stellen dann einen Triplexer für Mid Band, High Band und Band 66 dar. Dies entspricht der in der Figur 13 dargestellten Anordnung ohne die optionalen Elemente innerhalb der geschlossenen strichlierten Linie.

Die Antennenschalter AS1, AS2 und AS3 dienen dazu, den jeweiligen Signalpfad oder Teilpfad mit jeweils zumindest einem Bandkanal zu verbinden, der jeweils bidirektional für Sende- und Empfangssignale genutzt werden kann. In jedem Bandkanal ist eine Filtervorrichtung vorgesehen.

Im vorliegenden Ausführungsbeispiel sind vier Duplexer vorgesehen, die in jeweils einem Bandkanal angeordnet sind. Ein erster Duplexer dient zur RX-/TX-Trennung von Band 2. Ein weiterer Duplexer dient zur Trennung von RX/TX von Band 3. Weiter sind zwei neuartige gemischte Duplexer vorgesehen, bei denen TX- und RX-Filter unterschiedlichen Bändern zugehörig sind. Ein erster gemischter Duplexer vereint beispielsweise ein TX-Filter für Band 1 mit einem RX-Filter für Band 3. Ein zweiter gemischter Duplexer kombiniert ein RX-Filter von Band 2 mit einem TX-Filter von Band 4. So ist es beispielsweise möglich, RX-Signale von Band 2 über den reinen Band 2 Duplexer oder über den gemischten Duplexer auszufiltern. Entsprechendes gilt für RX-Signale von Band 3, die über den ersten gemischten Duplexer oder den reinen Band 3 Duplexer ausgefiltert werden können. Das Duplexing in Band 4 wird nicht über einen Duplexer vorgenommen. TX-Signale für Band 4 werden zwar im zweiten gemischten Duplexer zum ersten Antennenschalter AS1 geleitet, die RX-Signale von Band 4 werden dagegen über den ersten Extraktionspfad ausgeleitet, der ja auch die Frequenzen von Band 4 RX abdeckt. Das Duplexing für Band 1 funktioniert analog.

Am zweiten Antennenschalter AS2 für den High-Band-Bereich sind weitere Bandkanäle angeschlossen und wahlweise zuschaltbar, beispielsweise Duplexer für Band 7 und Band 30.

Es ist natürlich auch möglich, weitere Bandkanäle und die entsprechenden Filterelemente an den jeweiligen Antennenschalter für Low Band (Antennenschalter AS3), für Mid Band (Antennenschalter AS1) und für High Band (Antennenschalter AS2) anzuschließen.

Mit dem in Figur 13 dargestellten Frontend-Modul ist ein Downlink Carrier Aggregation Betrieb für RX-Signale von Band 1 und Band 3 möglich, obwohl beide im gleichen Bandbereich (Mid Band) angesiedelt sind. Da Low-Band- und High-Band-Bereich über andere Pfade ausgeleitet werden, sind auch Carrier Aggregation Modes möglich, bei denen ein Low Band, ein High Band mit Band 1 und Band 3 kombiniert sind. Eine solche Vierfach-Carrier-Aggregation kann zum Beispiel parallel in den Bändern B20, Bl, B3 und B7 arbeiten.

Da ein für Band 25 ausgelegtes Filter oder ein für Band 25 ausgelegter Duplexer gleichzeitig die Frequenzen von Band 2 mit abdeckt, genauso wie ein RX Filter für Band 66 auch die RX-Frequenzen von Band 4 und Band 1 abdeckt, sind mit den angegebenen Anordnungen Duplexer realisierbar, die weitere RX- und TX-Filter unterschiedlicher Bänder kombinieren, beispielsweise Band 4 TX mit Band 2 RX, Band 4 TX mit Band 25 RX, Band 66 TX mit Band 2 RX oder Band 66 TX mit Band 25 RX. Zusammen mit dem reinen Band 2 oder Band 25 Duplexer sind RX Carrier-Aggregation-Betriebsverfahren möglich, bei denen Band 2 und Band 4, Band 2 und Band 66, Band 25 und Band 4 oder Band 25 und Band 66 gleichzeitig oder parallel betrieben werden.

Da die Low-Band- und High-Band-Bereiche separiert sind, sind natürlich auch vier Bänder parallel betreibbar, beispielsweise in Band im Low Band, Band 25, Band 66 und ein Band im High Band Bereich. In einer speziellen Ausführung wird ein Downlink Carrier Aggregation Mode für Band 5, Band 25, Band 66 und Band 30 unterstützt.

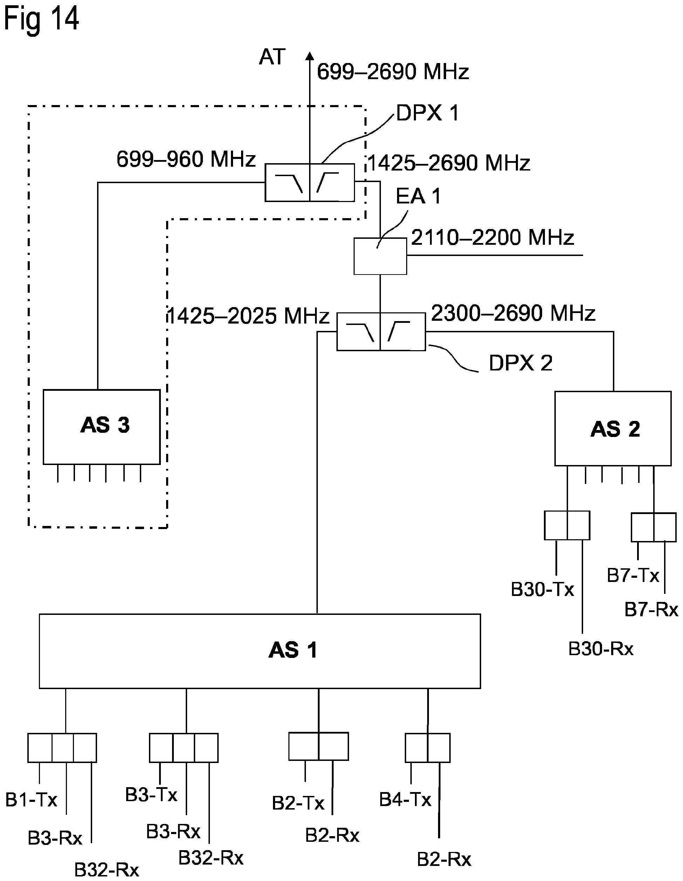

Figur 14 zeigt ein weiteres Ausführungsbeispiel eines Frontend-Moduls, welches bezüglich der Diplexer, der Extraktor-Anordnung und dem Vorsehen von drei Antennenschaltern AS1, AS2 und AS3 dem in Figur 13 dargestellten Ausführungsbeispiel entspricht. Unterschiedlich sind nur die an den ersten Antennenschalter AS1 angeschlossenen Bandkanäle.

Für dieses Ausführungsbeispiel wird vorgeschlagen, gemischte mikroakustische Triplexer mit dem Antennenschalter AS2 zu verbinden, um so im jeweiligen Bandkanal ein Triplexing zu ermöglichen. Ein erster Triplexer umfasst beispielsweise Filter für Band 1 TX/Band 3 RX/Band 32 RX. Ein weiterer mikroakustischer Triplexer umfasst Filter für Band 1 TX/Band 3 RX/Band 32 RX. Mit diesen zwei Triplexern und einer Extraktor-Anordnung für Band 66 (bzw. Band 1 oder Band 4) ist ein Carrier-Aggregation-Betriebsverfahren für drei Empfangsbänder möglich, welches parallel in Band 1, Band 3 und Band 32 operieren kann.

Da mit dem vorgestellten Modul Low-Band- und High-Band-Bereiche separiert sind, sind auch Downlink Carrier-Aggregation-Betriebsarten zumindest in fünf RX Bändern möglich. Dabei können z.B. ein Band im Low-Band-Bereich, Band 1, Band 3, Band 32 und ein Band aus dem High Band-Bereich kombiniert und parallel in RX betrieben werden. Es ist beispielsweise ein Carrier-Aggregation-Betrieb in Band 20, Band 1, Band 3, Band 32 und Band 7 möglich.

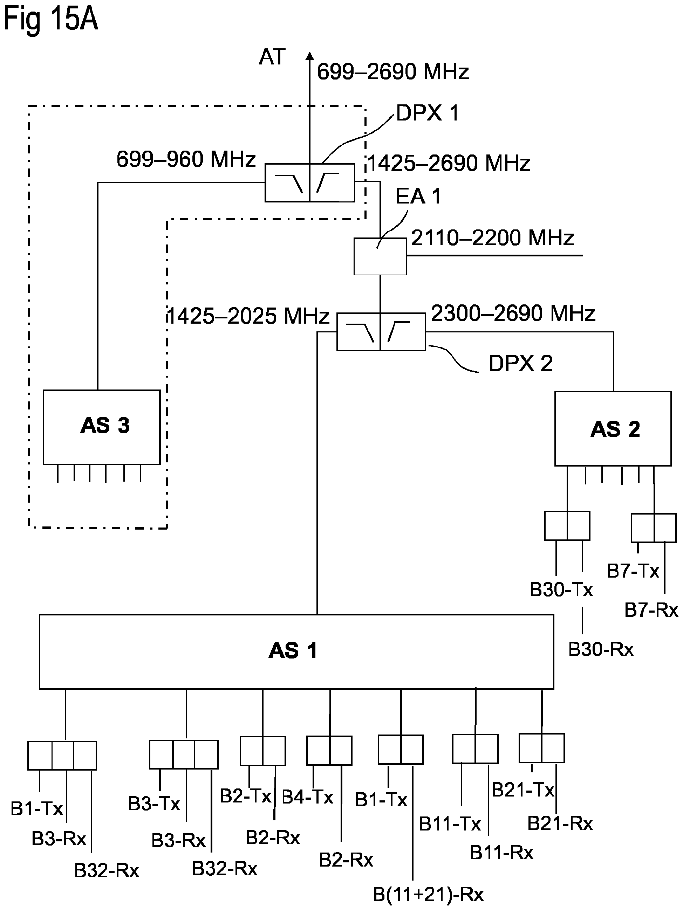

Auch das Ausführungsbeispiel nach Figur 15A unterscheidet sich mit Ausnahme der an den ersten Antennenschalter AS1 angebundenen Bandkanäle bzw. der darin enthaltenen Filterelemente nicht von den Ausführungen nach den Figuren 13 und 14. Zusätzlich zu den in Figur 14 dargestellten Bandkanälen werden hier drei neuartige mikroakustische gemischte Duplexer für japanische Bänder bzw. für in Japan genutzte Bänder vorgesehen.

Ein erster gemischter Duplexer bedient Band 1 TX und die Kombination von Band 11 plus Band 21 RX. Das letztgenannte RX-Filter umfasst die aneinandergrenzenden und nicht überlappenden schmalen Frequenzbereiche für Band 11 RX und Band 21 RX. Ein zweiter neuartiger gemischter Duplexer umfasst Band 1 TX und Band 11 RX. Ein dritter neuartiger gemischter Duplexer umfasst Band 1 TX und Band 21 RX. Jeder einzelne der drei genannten gemischten Duplexer kann in Verbindung mit einem reinen Band 11 oder Band 21 Duplexer und der Extraktor-Anordnung für Band 66 einen Carrier-Aggregation-Betrieb für Band 1 und Band 11 oder für Band 1 und Band 21 bezüglich RX ermöglichen.

Da der Low-Band-Bereich und der High-Band-Bereich durch getrennte Signalpfade vom ersten Antennenschalter AS1 separiert sind, sind natürlich auch Carrier-Aggregation-Verfahren möglich, bei denen ein Band des Low-Band-Bereichs plus Band 1 plus Band 11 (Band 21) und ein High Band aus dem High-Band-Bereich kombiniert werden. So wird beispielsweise ein Downlink Carrier Aggregation Mode unterstützt, in dem ein Betrieb in and 18, Band 1, Band 11 (und/oder Band 21) und Band 7 möglich ist. Natürlich können auch andere Bänder des High-Band- und Low-Band-Bereichs alternativ dazu kombiniert werden, beispielsweise Band 30 für den High-Band-Bereich.

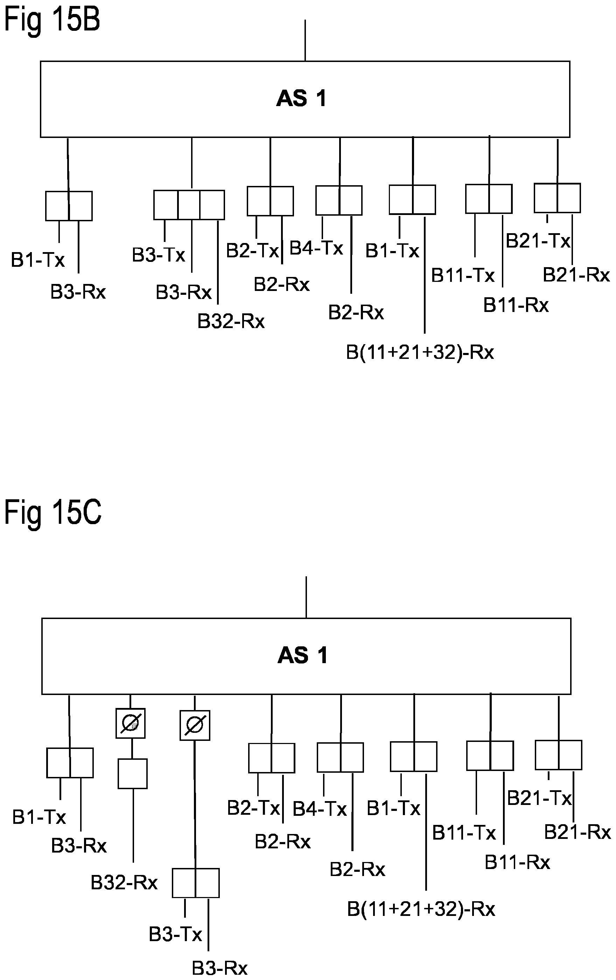

Auch das Ausführungsbeispiel nach Figur 15B unterscheidet sich mit Ausnahme der an den ersten Antennenschalter AS1 angebundenen Bandkanäle bzw. der darin enthaltenen Filterelemente nicht von den Ausführungen nach den Figuren 13, 14 und 15A.

An den Antennenschalter AS1 ist ein neuer gemischter Duplexer angebunden, der das Bl-oder B65-Tx Band mit einem sehr breiten Rx-Band (1427.9 - 1510.9 MHz) kombiniert, das die Rx-Bänder von Band 11, Band 21 und B32 abdeckt. Damit kann der Bl- oder B65-Tx / B3-Rx / B32-Rx Triplexer durch einen einfacheren gemischten Duplexer Bl- oder B65- Tx / B3-Rx ersetzt werden. Trotzdem werden immer noch zumindest die folgenden Downlink-Carrier-Aggregation-Fälle abgedeckt, die Kombinationen von zwei Bändern aus dem "Cellular Mid Band" beinhalten (plus andere Bänder aus dem Low Band und/oder High Band):
a.) Bl/B65 + B3 CA
b.) Bl/B65 + B32 CA
c.) B3 + B32 CA
d.) Bl/B65 + B11 CA
e.) Bl/B65 + B21 CA
f.) B2/B25 + B4/B66 CA

Möglich ist es auch, den Bl- (oder B65-)Tx / B(11+21+32)-Rx Duplexer durch einen Bl-(oder B65-)Tx / B3-Rx / B(11+21+32)-Rx Triplexer zu ersetzen. Dann kann der gemischte Duplexer Bl- oder B65-Tx / B3-Rx entfallen.

Zusätzlich zu den oben genannten CA Kombinationen von zwei Bändern aus dem Mid Band ist dann auch noch die folgende Kombination von drei Bändern aus dem "Cellular Mid Band" möglich, zu denen natürlich noch andere Bänder aus dem Low Band und/oder High Band hinzu kombiniert werden können:
g.) B1 + B3 + B32 CA

Auch das Ausführungsbeispiel nach Figur 15C unterscheidet sich mit Ausnahme der an den ersten Antennenschalter AS1 angebundenen Bandkanäle bzw. der darin enthaltenen Filterelemente nicht von den Ausführungen nach den Figuren 13, 14, 15A und 15B. Hier gibt es folgende Unterschiede im Vergleich zum Ausführungsbeispiel nach Fig. 15B:
Der B3-Tx / B3-Rx / B32-Rx Triplexer wird in einen normalen B3-Tx / B3-Rx Duplexer und ein B32-Rx Einzelfilter aufgespaltet bzw. wird der Triplexer durch diese genannten Filterelemente ersetzt, denen jeweils eine Phasenschieberschaltung vorgeschaltet ist. Der B3 Duplexer und das B32 Filter werden nur bei Bedarf zusammengeschaltet. Hierbei muss dann der Antennenschalter AS1 einen Zustand unterstützen, bei dem der B3 Duplexer und das B32 Filter gleichzeitig mit dem Eingang des Antennenschalters AS1 verbunden sind. In diesem Zustand dienen die Phasenschieber dazu, die Gegenbandimpedanzen (also die Impedanz des jeweiligen Filters/Duplexers im jeweiligen Gegenband) jeweils so einzustellen, dass die Zusammenschaltung mit niedriger Einfügedämpfung möglich wird.

Außerdem kann der Antennenschalter AS1 den B3 Duplexer und das B32 Filter einzeln mit seinem Eingang verbinden.

In dieser Konstellation werden dann nur Duplexer plus ein Einzelfilter benötigt, um die oben angeführten CA-Fälle a. bis f. (wie in Fig. 15B beschrieben) abzudecken.

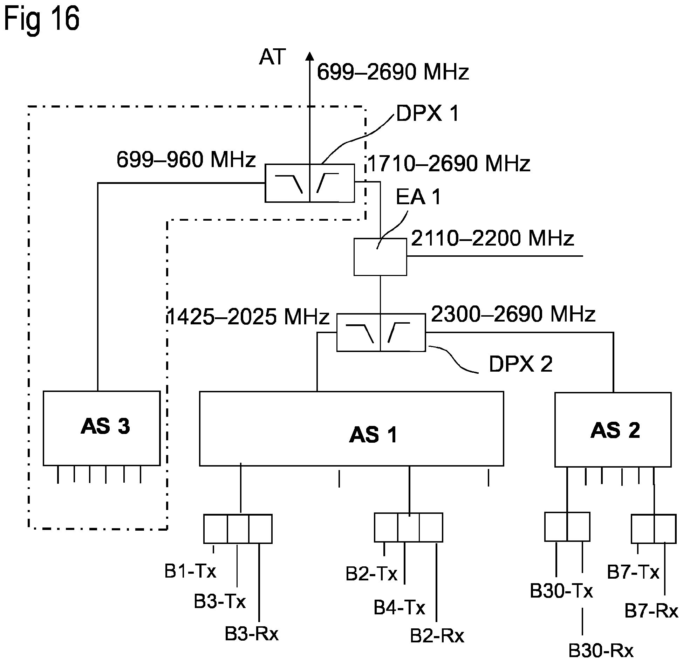

Das Ausführungsbeispiel eines weiteren Frontend-Moduls ist in Figur 16 dargestellt. Auch diese Ausführung unterscheidet sich bis zu den Antennenschaltern nicht von den Ausführungen gemäß den Figuren 13 bis 15. Diese Ausführungsform zeichnet sich durch zwei neuartige mikroakustische Triplexer aus. Ein erster kombiniert Band 1 TX mit Band 3 TX und Band 3 RX. Ein zweiter neuer Triplexer kombiniert Band 2 Tx (bzw. Band 25 Tx) mit Band 4 Tx (bzw. Band 66 Tx) mit Band 2 Rx (bzw. Band 25 RX).

Zusammen mit der Extraktor-Anordnung, die das Rx Band von Band 1, Band 4 oder Band 66 aus dem Signalpfad extrahiert, erlauben diese beide Triplexer Up- und Downlink Carrier-Aggregation-Betrieb für die CA Kombination Band 1 (bzw. Band 66) plus Band 3, des weiteren auch für die CA Kombinationen Band 2 (bzw. Band 25) plus Band 4 (bzw. Band 66). Weiterhin ist es möglich, da Low-Band- und High-Band-Bereiche über andere Signalpfade ausgeleitet werden, zusätzlich jeweils ein Band aus diesen beiden Bereichen dazu zu kombinieren.

So ist es beispielsweise möglich, ein Low-Band-Band mit Band 1 (Band 65), Band 3 und einem High-Band-Band zu kombinieren, alternativ ein Low-Band-Band mit Band 4 (Band 66) und Band 2 (Band 25) zusammen mit einem Band aus dem High Band Bereich zu betreiben. Beispielhafte Bandkombinationen sind beispielsweise Band 20/Band 1/Band 3/Band 7 oder Band 12/Band 4 (Band 66)/Band 2 (Band 25)/Band 30. Alle Fälle sind für einen Up- und Downlink Carrier-Aggregation-Betrieb geeignet.

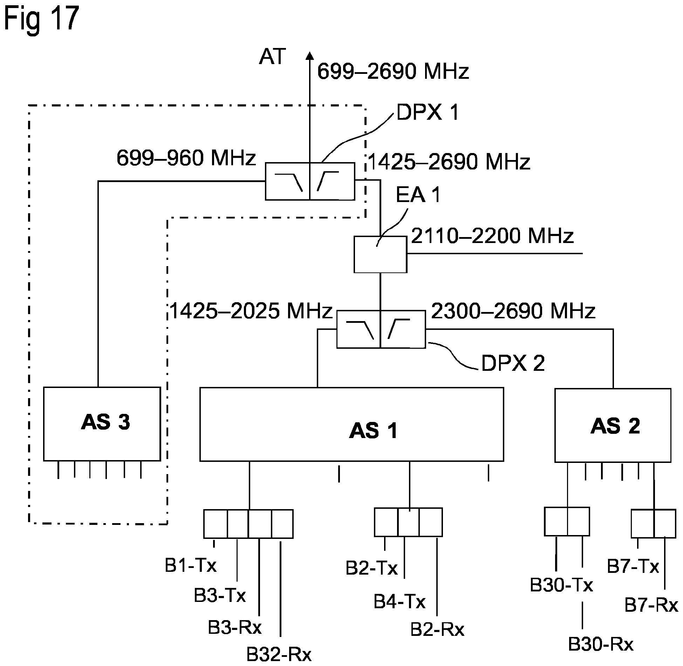

Auch das in Figur 17 dargestellte Ausführungsbeispiel unterscheidet sich nur durch die an den ersten Antennenschalter AS1 angebundenen Bandkanäle bzw. die darin enthaltenen Filterelemente. In einem Bandkanal ist ein neuer mikroakustischer Quadplexer angeordnet, der Filterelemente für Band 1 TX/Band 3 TX/Band 3 RX und Band 32 RX umfasst. Wird dieser Quadplexer zusammen mit der Extraktor-Anordnung für Band 66 oder Band 1 oder Band 4 betrieben, so ist ein Up- und Downlink Carrier-Aggregation-Betrieb für Band 1, Band 3 und Band 32 möglich, wobei Band 32 ein reines Rx Band ist.

Da die Low- und High-Band-Bereiche separiert sind, ist mit dem vorgeschlagenen Frontend-Modul zusätzlich jeweils noch ein Band aus dem Low-Band- und dem High-Band-Bereich kombinierbar, beispielsweise eine Bandkombination aus Band 20/Band 1/Band 3/Band 32/Band 7. Wie in Figur 17 gezeigt, ist neben dem neuartigen Quadplexer dazu noch der bereits in Figur 16 beschriebene Triplexer mit Band 2 TX/Band 4 TX und Band 2 RX erforderlich.

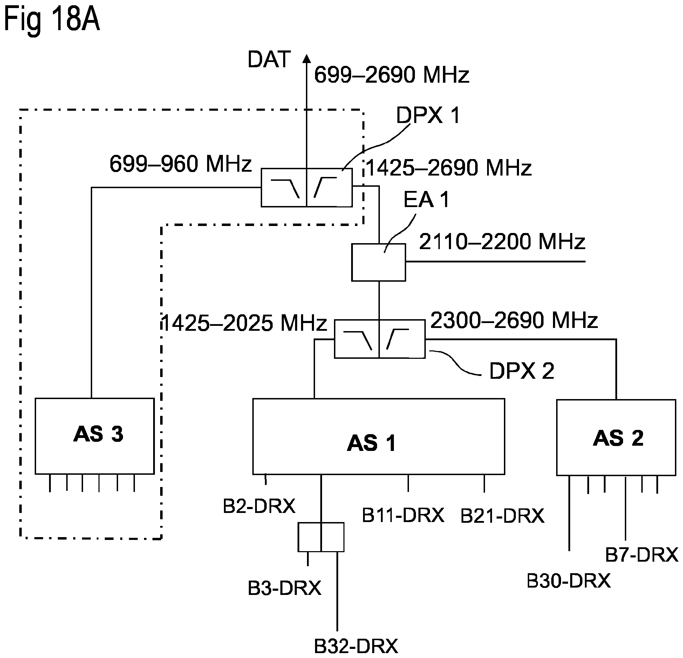

Figur 18A zeigt ein Ausführungsbeispiel, in dem ein erfindungsgemäßes Frontend-Modul mit einer Diversity-Antenne DAT verbunden und zusammen mit dieser für einen reinen Empfangsbetrieb ausgestaltet werden kann. Für die Hardware-Komponenten inklusive der Antennenschalter, kann die gleiche Anordnung verwendet werden, wie sie bereits in den Ausführungsbeispielen anhand der Figuren 13 bis 17 beschrieben wurde. Im Unterschied zu den bisherigen Ausführungen sind mit den Antennenschaltern jedoch jetzt nur noch reine Empfangsfilterelemente verbunden, wobei sich das Ausführungsbeispiel durch neuartige Diplexer auszeichnet, die hinter dem Antennenschalter eines Diversity-Moduls angeordnet sind und die Empfangsfilter zweier unterschiedlicher Bänder kombinieren. Mit dem ersten Antennenschalter AS1 für den Mid-Band-Bereich wird hierzu ein gediplextes Diversity-Empfangsfilter vorgeschlagen, welches Filter für Band 1 RX und Band 32 RX kombiniert. Dieses gediplexte Diversity-Empfangsfilter ermöglicht zusammen mit der Extraktor-Anordnung für Band 66/Band 4/Band 1 eine reine Empfangs-Carrier-Aggregation für Band 1 mit Band 3 und Band 32, die an der Diversity-Antenne betrieben werden kann.

Da Low-Band-Bereich und High-Band-Bereich davon abgetrennter Signalpfade separiert sind, können mit der Diversity-Antenne DAT jeweils noch zwei weitere Bänder parallel dazu betrieben werden, jeweils eines aus dem Low-Band- und aus dem High-Band-Bereich. Eine beispielhafte Bänderkombination für den Diversity-Betrieb umfasst die Bänder 20, 1, 3, 32 und 7.

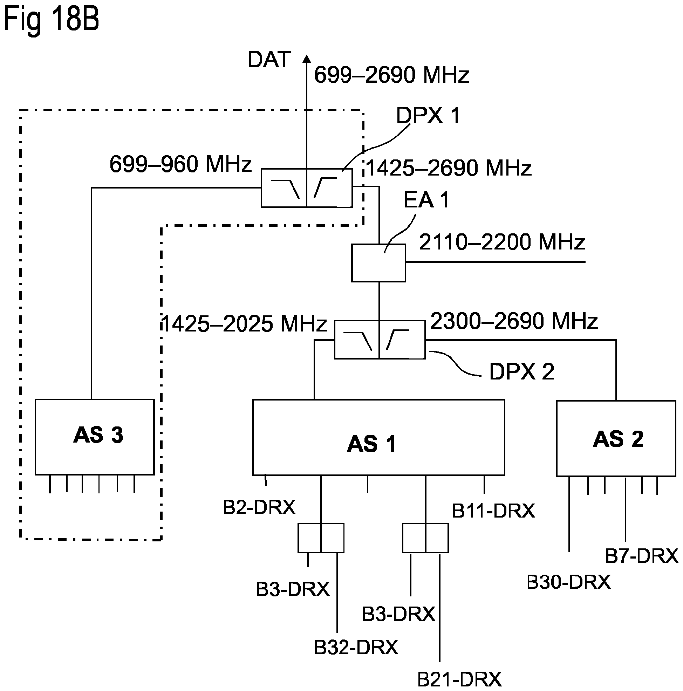

Ein weiteres in Figur 18B gezeigtes Frontend-Modul mit Antennenanschluss für eine Diversity-Antenne DAT weist am ersten Antennenschalter AS1 ein neues mikroakustisches gediplextes Diversity-Empfangsfilter auf, welches Filterelemente für Band 3 RX und Band 21 RX kombiniert. Zusammen mit einer Extraktor-Anordnung, die Band 66/Band 1/Band 4 zu extrahieren vermag, wird mit diesem gediplexten Diversity-Empfangsfilter ein reiner Empfangs-Carrier-Aggregation-Betrieb für die Bänder 21, B3 und B1 an der Diversity-Antenne möglich. Wegen der separierten Low-Band- und High-Band-Bereiche kann jeweils noch ein Empfangsband im Low- und High-Band-Bereich dazu kombiniert werden. Möglich ist es dann beispielsweise, das vorgestellte Frontend-Modul an der Diversity-Antenne für einen Carrier-Aggregation-Empfangsbetrieb zu ertüchtigen, welches die Bänder 19, 21, 3, 1 und 7 gleichzeitig unterstützt.

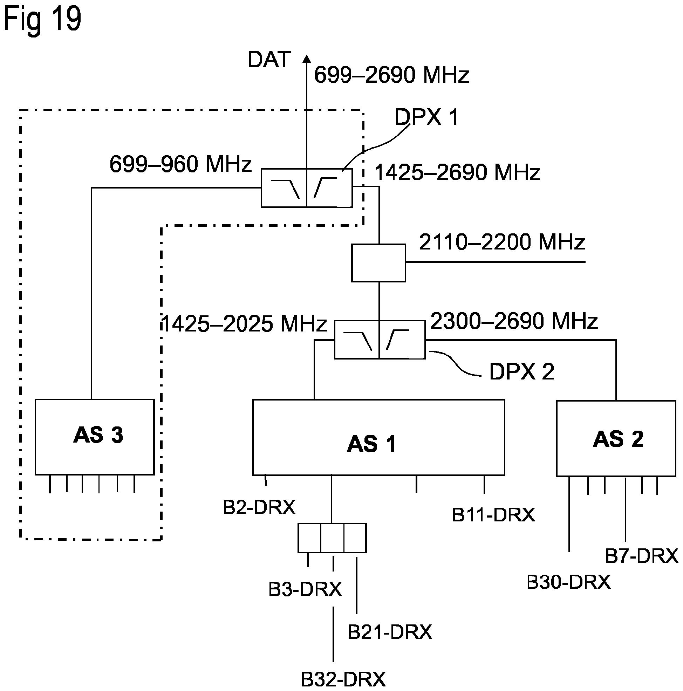

Ein weiteres Ausführungsbeispiel für ein mit der Diversity-Antenne DAT verbindbares Frontend-Modul ist in Figur 19 dargestellt, welches sich wiederum nur durch die mit dem ersten Antennenschalter AS1 verbundenen Filterelemente von den Ausführungen gemäß der Figuren 18A und 18B unterscheidet. Hierzu wird mit dem ersten Antennenschalter AS1 ein mikroakustisch getriplextes Diversity-Empfangsfilter verbunden. Dieses umfasst Diversity-Empfangsfilter für Band 32/Band 21/Band 3. Zusammen mit einer Extraktor-Anordnung für Band 66/Band 1/Band 4 wird eine reine Empfangs-Carrier-Aggregation an der Diversity-Antenne ermöglicht, sodass gemeinsamer Empfangsbetrieb in den Bändern 21 und 3 und 1 oder in den Bändern 32 und 1 oder in den Bändern 1 und 11 möglich ist. Zusätzlich mit jeweils einem Empfangsfilter aus dem Low-Band- und dem High-Band-Bereich beispielsweise sind an der Diversity-Antenne DAT Carrier Aggregation Modes für den gleichzeitigen Betrieb der Bänder 20, 32, 3, 1 und 7 oder alternativ B19, B21, B3, B1 und B7 möglich.

Während die in den bisherigen Ausführungsbeispielen gemäß der Figuren 13 bis 19 gezeigten Frontend-Module jeweils eine Extraktor-Anordnung für Band 66 bzw. 4 bzw. 1 aufweisen, wird im Folgenden auf Frontend-Module eingegangen, welche eine Extraktor-Anordnung zum Extrahieren von Band 40 (bzw. Band 30) umfassen.

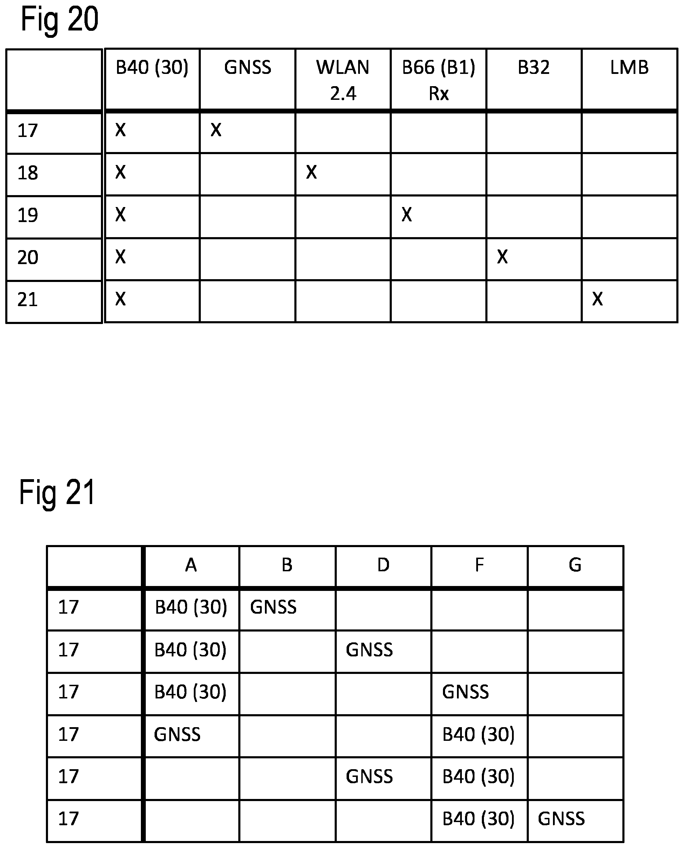

Figur 20 zeigt eine Tabelle mit verschiedenen Kombinationsmöglichkeiten einer Band 40 Extraktor-Anordnung mit zumindest einer weiteren Extraktor-Anordnung, die wahlweise ausgelegt ist für GNSS, WLAN 2.4, Band 66, Band 32 oder ein Band aus LMB.

Figur 21 zeigt beispielhaft, wie die in Figur 20 genannte Kombination 17 aus Extraktor-Anordnungen für Band 40 und GNSS über die Extraktorpositionen gemäß dem schematischen Frontend-Modul von Figur 4 aufgeteilt werden können. Während für die Extraktor-Anordnung für Band 40 nur eine Position A vor dem ersten Diplexer DPX1 sowie eine Position F zwischen erstem Diplexer und zweitem Diplexer DPX2 möglich ist, lässt sich die Extraktor-Anordnung für GNSS auf fast allen Extraktor-Positionen anordnen.

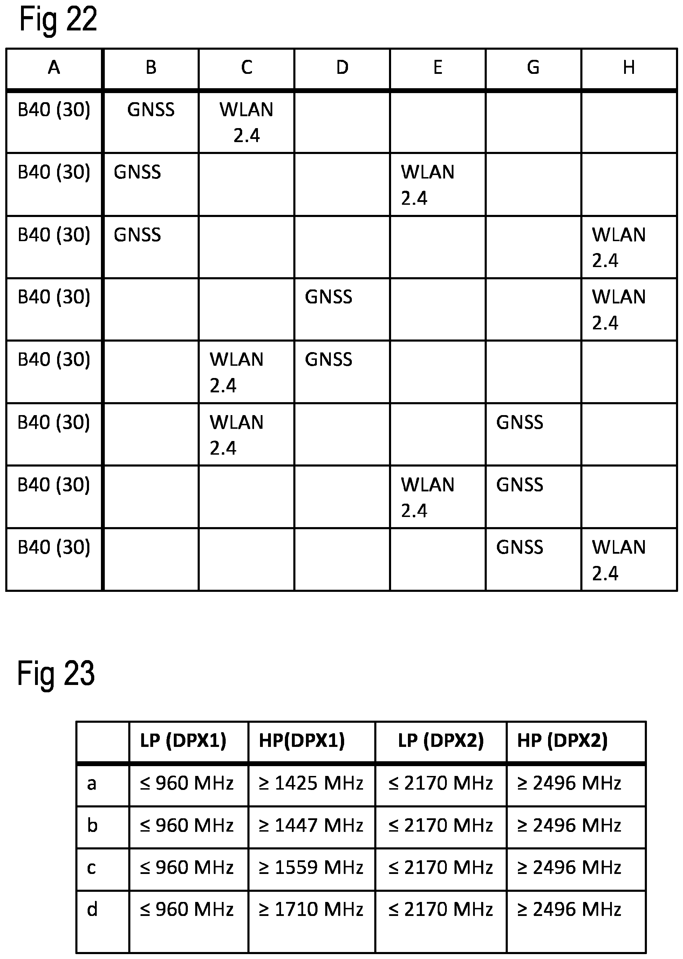

Figur 22 zeigt acht Möglichkeiten, wie drei unterschiedliche Extraktor-Anordnungen für Band 40, GNSS und WLAN 2.4 über die Extraktor-Positionen gemäß Figur 4 in einem Frontend-Modul verteilt werden können. Für solche Dreierkombinationen ist es vorteilhaft, den Band 40 Extraktor zwischen erstem und zweitem Diplexer DPX1/DPX2 anzuordnen, also beispielsweise auf der Position A.

Mit Extraktorkombinationen, die Band 40 umfassen, sind die Frequenzbereiche der Diplexer in Abhängigkeit von dem Band 40 Extraktor neu zu konfigurieren

Figur 23 zeigt vier Möglichkeiten, wie die Durchlassbereiche von Hochpass und Tiefpass der Diplexer 1 und 2 eingestellt werden können. Für alle vier Möglichkeiten a, b, c und d sperrt der Tiefpass des ersten Diplexers oberhalb von 960 MHz. Der Hochpass des ersten Diplexers DPX1 kann ein Passband aufweisen, welches gemäß Ausführung a bei 1425 MHz, gemäß Ausführung b bei 1447 MHz, gemäß Ausführung c bei 1559 MHz oder gemäß Ausführung d bei 1710 MHz beginnt. In allen Ausführungen a bis d sperrt der Tiefpass des zweiten Diplexers DPX2 ab einer Frequenz von 2170 MHz, während dessen Hochpass für Frequenzen > 2496 MHz durchlässig ist.

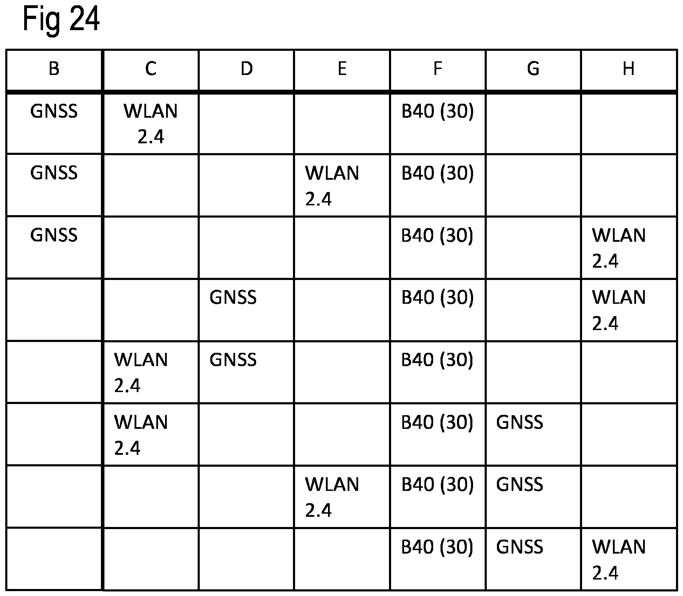

Figur 24 zeigt weitere davon unterschiedliche Anordnungsmöglichkeiten für die Extraktorkombination GNSS/WLAN 2.4/Band 40 über die Extraktorpositionen gemäß Figur 4.

Als gemeinsames Merkmal dieser vorgeschlagenen Anordnungen ergibt sich, dass der Extraktor für Band 40 sinnvollerweise auf einer Position zwischen Antennenanschluss und erstem Diplexer positioniert wird. Die beiden übrigen Extraktor-Anordnungen können nahezu frei über die übrigen Extraktorpositionen verteilt werden. Auch für diese Verteilung werden die Diplexer bezüglich der Frequenzbereiche gemäß Figur 23 konfiguriert.

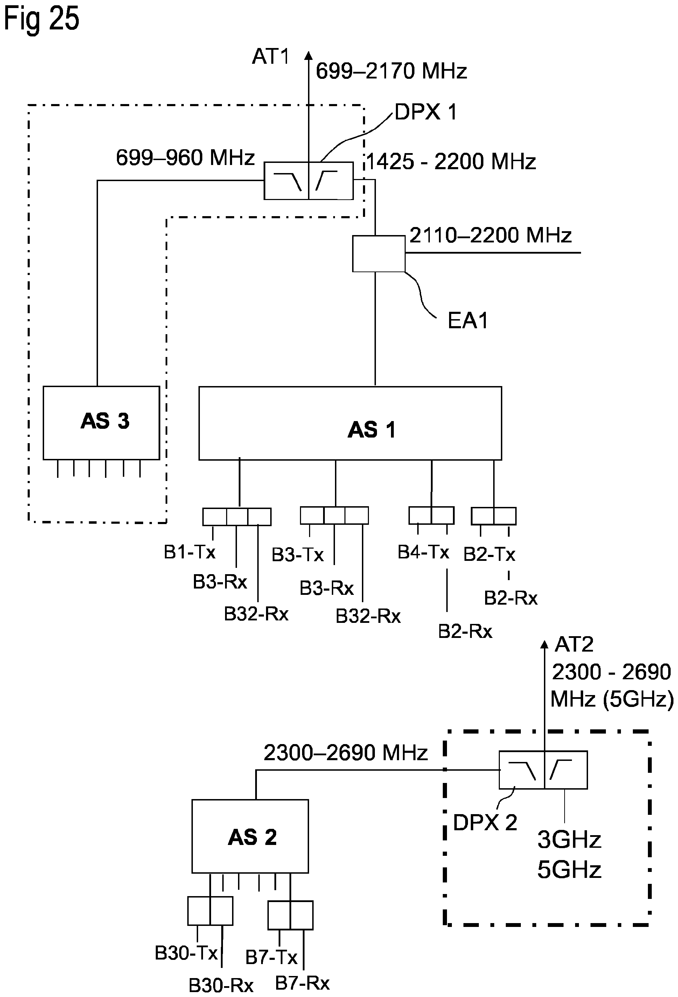

Figur 25 zeigt ein Frontend-Modul mit einem Diplexer und einer Extraktor-Anordnung. Ein erster Antennenanschluss AT1 ist mit dem ersten Diplexer DPX1 verbunden, welcher über ein Tiefpassfilter einen Low-Band-Bereich bis 960 MHz abtrennt. Das Hochpassfilter des ersten Diplexers ist insbesondere zur Abtrennung eines Mid-Band-Bereichs von 1425 MHz bis 2200 MHz ausgelegt. Zwischen dem Hochpass und dem ersten Antennenschalter AS1 ist eine Extraktor-Anordnung vorgesehen, mit der ein dem Band 66 Rx bzw. Band 1, 4 und 65 Rx entsprechendes Extraktorband aus dem Signalpfad extrahiert werden kann.

Die Extraktor-Anordnung EA1 ist optional mit einem Überbrückungspfad versehen, mit dessen Hilfe die Extraktor-Anordnung deaktiviert werden kann.

Hinter der Extraktor-Anordnung ist der erste Antennenschalter AS1 angeordnet, dessen Ausgänge mit zwei speziellen Triplexem verbunden werden können. Ein erster Triplexer kombiniert ein TX-Filter für Band 66 (Band 1), ein RX-Filter für Band 3 und ein RX-Filter für Band 32. Ein zweiter Triplexer kombiniert ein TX-Filter für Band 3 mit einem RX-Filter von Band 32 und einem RX-Filter von Band 3.

Weiterhin ist mit dem Ausgang des Antennenschalters AS1 ein gemischter Duplexer verbunden, welcher ein TX-Filter für Band 66/4 mit einem RX-Filter für Band 2 (Band 25) verbindet. Mit dieser Kombination eines Diplexers und den mit dem ersten Antennenschalter AS1 verbundenen Triplexem und Duplexem kann das vorgeschlagene Frontend-Modul den Vierfach- Downlink Carrier-Aggregation-Mode unterstützen, bei dem parallel die Bänder Bl/B65, B3, B7 und B32 aktiv sind. Ein weiterer unterstützter Carrier Aggregation Mode für vier Bänder umfasst Band 12 (oder Band 5 oder Band 29), Band 2 (oder Band 25), Band 66/4 und Band 30, ohne dass dafür Quadplexer oder Hexaplexer erforderlich wären.

Neben dem ersten Antennenanschluss AT1, der mit einer ersten Antenne verbindbar ist, weist das Modul noch einen zweiten Antennenanschluss AT2 auf, der mit einer zweiten Antenne verbindbar ist. Die zweite Antenne ist für einen Frequenzbereich von 2300 MHz bis 2690 MHz ausgelegt und kann optional bis in den 5 GHz Bereich empfangen. Mit der zweiten Antenne ist ein zweiter Diplexer DPX2 verbunden, der über einen Tiefpass einen High-Band-Bereich abtrennt und einem zweiten Antennenschalter AS2 zuleitet. Dieses High Band ist für einen Frequenzbereich von 2300 MHz bis 2690 MHz ausgelegt. Möglich ist es auch, anstelle eines zweiten Diplexers einen Triplexer mit der zweiten Antenne zu verbinden. Dieser Triplexer kann dann so ausgelegt sein, dass er neben dem oben genannten Frequenzbereich Highband zusätzlich noch das Ultrahighband und den 5 GHz Bereich abtrennt.

Mit dem Ausgang des zweiten Antennenschalters AS2 sind außerdem herkömmliche reine Duplexer für Band 30 und Band 7 verbunden.

Am Hochpass des zweiten Diplexers DPX2 wird ein 3 GHz Frequenzbereich (optional bis 5 GHz) abgetrennt. Wenn auf diesen Frequenzbereich verzichtet werden kann, kann der zweite Antennenschalter direkt mit dem zweiten Antennenanschluss AT2 verbunden werden und auf den zweiten Diplexer DPX2 verzichtet werden, so wie die strichlierte Linie diese optionalen Komponenten umschließt.

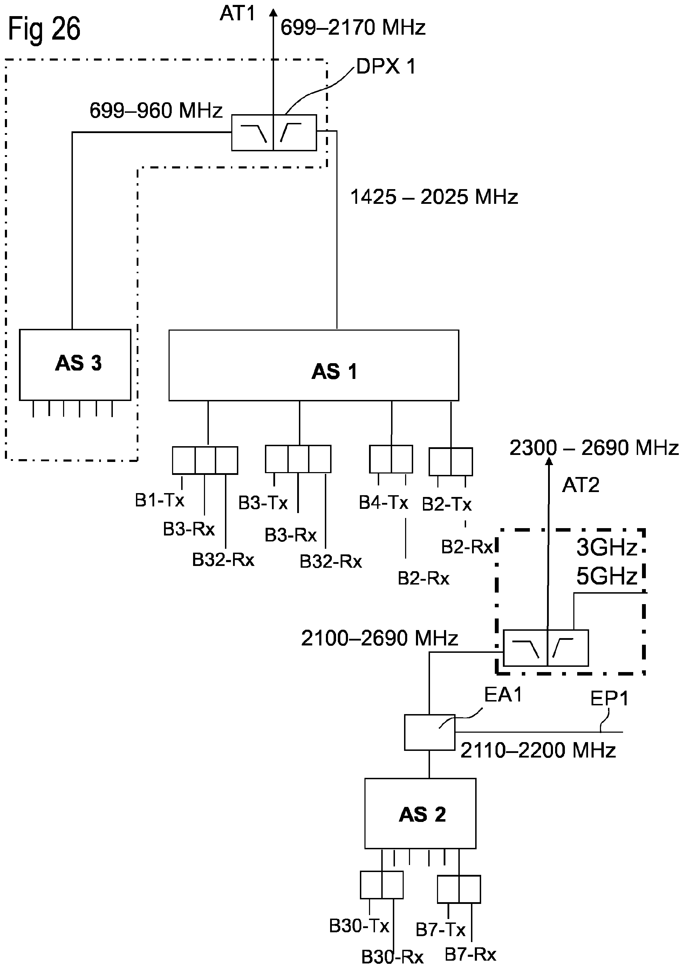

Figur 26 zeigt ein weiteres Ausführungsbeispiel der Erfindung, bei dem das Frontend-Modul zwei Antennenanschlüsse AT1 und AT2 umfasst, die mit zwei unterschiedlichen Antennen verbindbar sind. Die erste Antenne bzw. der erste Antennenanschluss AT1 ist zum Einspeisen von Signalen von 699 MHz bis 2170 MHz ausgelegt. Mit dem Tiefpass eines ersten Diplexers DPX1 wird ein Low-Band-Bereich zwischen 699 MHz und 966 MHz abgetrennt und einem dritten Antennenschalter AS3 zugeleitet.

Der Hochpass des ersten Diplexers DPX1 trennt einen Frequenzbereich von 1425 MHz bis 2025 MHz ab und leitet diesen einem ersten Antennenschalter AS1 zu.

Ein zweiter Antennenanschluss, der mit der zweiten Antenne verbindbar ist, ist zur Einspeisung von Frequenzen von 2300 MHz bis 2690 MHz ausgelegt. Zwischen zweitem Antennenanschluss AT2 und einem zweiten Antennenschalter AS2 ist eine Extraktor-Anordnung vorgesehen, die zum Extrahieren von Band 1/4/65/66 Rx ausgelegt ist. Mit dem zweiten Antennenschalter AS2 sind reine Duplexer für Bänder des High-Band-Bereichs, beispielsweise Duplexer für Band 30 und Band 7, verbunden.

Mit dem Ausgang des ersten Antennenschalters AS1 sind zwei spezielle Triplexer verbunden, von denen der erste die folgenden Filterelemente kombiniert: ein TX-Filter für Band 1/65 mit einem RX-Filter für Band 3 und einem RX-Filter für Band 32. Der zweite Triplexer kombiniert ein TX-Filter für Band 3 mit einem RX-Filter für Band 3 und einem RX-Filter für Band 32.

Ein gemischter Duplexer am ersten Antennenschalter AS1 kombiniert ein TX-Filter für Band 4 (Band 66) mit einem RX-Filter für Band 2 (Band 25). Ebenfalls am ersten Antennenschalter AS1 angehängt ist ein reiner Band 2 (Band 25) Duplexer. Mit diesen speziellen Triplexem und dem speziellen Duplexer ist ein Vierfach-Downlink Carrier-Aggregation-Mode möglich, bei dem die Bänder 1, 3, 7 und 32 parallel betrieben werden können. Alternativ können die Bänder 12 (oder 5 oder 29), 2, 4 und 30 parallel betrieben werden, ohne dass dafür ein zellularer Quadplexer oder Hexaplexer erforderlich ist.

In einer optionalen Erweiterung ist zwischen dem zweiten Antennenanschluss AT2 und der ersten Extraktor-Anordnung EA1 ein Diplexer vorgesehen, der den Frequenzbereich zwischen 3 GHz und 5 GHz abtrennt

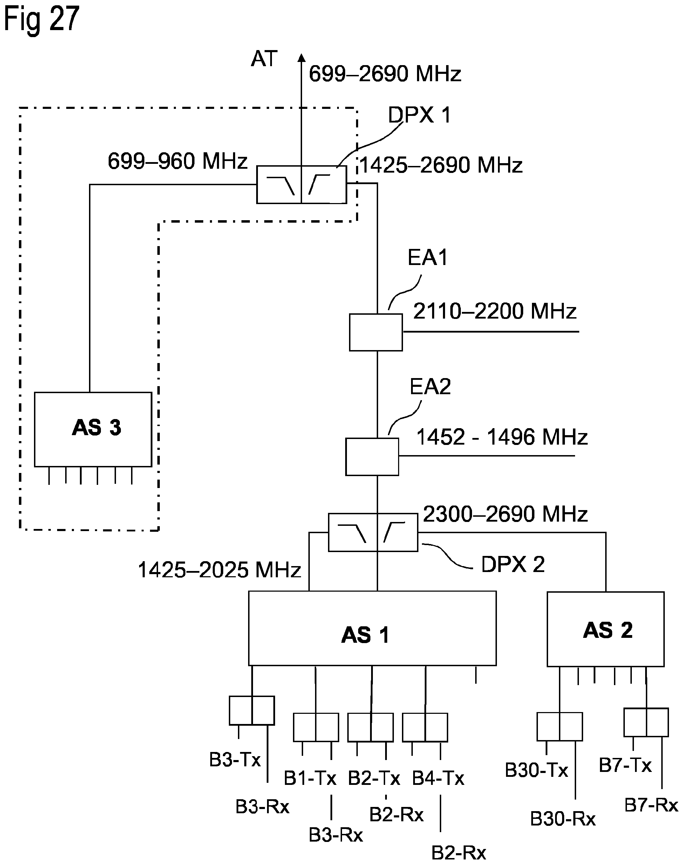

Das Frontend-Modul gemäß Figur 27 weist zwei Extraktor-Anordnungen auf, die zum Extrahieren von RX-Frequenzen von Band 66 und von Band 32 ausgelegt sind
Das Frontend-Modul verbindet einen Antennenanschluss AT, über den Frequenzen von 699 MHz bis 2690 MHz eingespeist werden können, mit einem ersten Diplexer DPX1, der am Tiefpass ein Low Band von 699 MHz bis 960 MHz abtrennt. Am Ausgang des Hochpasses des ersten Diplexers DPX1 werden Frequenzen von 1425 MHz bis 2690 MHz ausgeleitet. Innerhalb dieses mit dem Hochpass des ersten Diplexers DPX1 verbundenen Signalpfads sind nun die beiden Extraktor-Anordnungen EA1 und EA2 angeordnet. Daran schließt sich der zweite Diplexer DPX2 an, der am Tiefpass Frequenzen des Mid Bands von 1425 MHz bis 2025 MHz separiert und einem ersten Antennenschalter AS1 zuweist. Am Hochpass des zweiten Diplexer DPX2 wird ein High Band von 2300 MHz bis 2690 MHz ausgeleitet und einem zweiten Antennenschalter AS2 zugeführt.

Mit dem Ausgang des ersten Antennenschalters AS1 sind zwei neuartige gemischte Duplexer verbunden. Ein erster kombiniert ein TX-Filter für Band 1/65 mit einem RX-Filter für Band 3. Ein zweiter gemischter Duplexer kombiniert ein TX-Filter für Band 4/66 mit einem RX-Filter für Band 2 (Band 25). Weiter sind mit dem ersten Antennenschalter AS1 reine Duplexer für Band 2 (Band 25) und Band 3 verbunden.

Diese Ausführung zeichnet sich insbesondere dadurch aus, dass keine zellulare Quad-oder Hexaplexer benötigt werden.

Werden im Frontend-Modul keine Bänder des Low-Band-Bereichs benötigt oder wird der Low-Band-Bereich über eine zweite Antenne bedient, so kann auf den ersten Diplexer DPX1 verzichtet werden und der erste Antennenanschluss AT direkt mit den beiden Extraktor-Anordnungen verbunden werden.

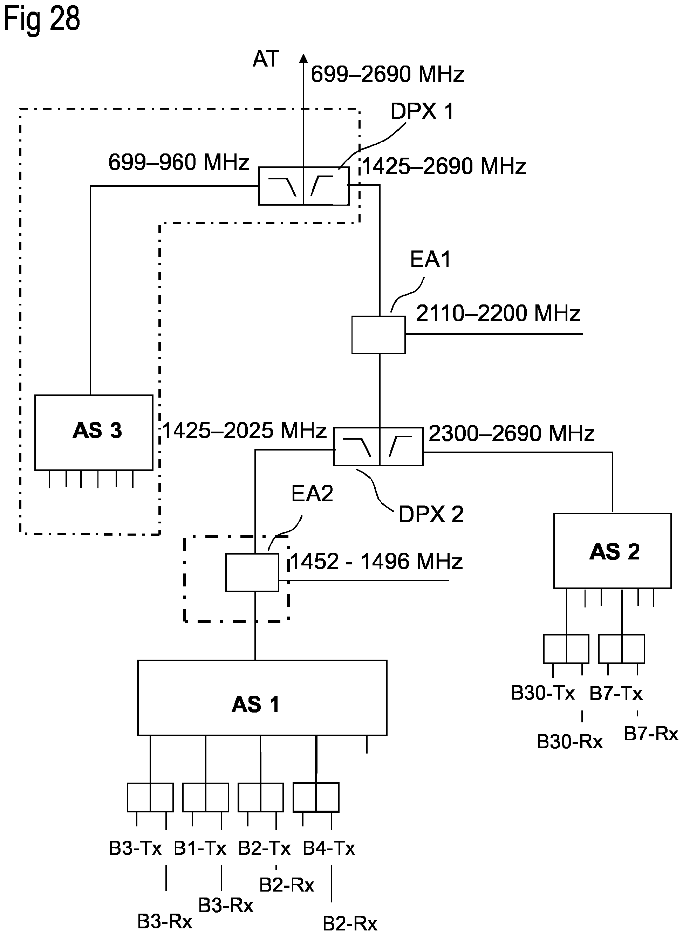

Figur 28 zeigt ein Ausführungsbeispiel, bei dem ähnlich wie in Figur 27 zwei unterschiedliche Extraktor-Anordnungen zum Extrahieren von Band 66 (4/1/65) RX und von Band 32 RX vorgesehen sind, jedoch in anderer Anordnung als im Beispiel nach Figur 27.

Der Antennenanschluss AT ist mit einem ersten Diplexer DPX1 verbunden, der am Tiefpass ein Low Band bis 960 MHz abtrennt. Am Hochpass werden Frequenzen von 1425 MHz bis 2690 MHz ausgeleitet und über eine erste Extraktor-Anordnung EA1 einem zweiten Diplexer DPX2 zugeleitet. Die erste Extraktor-Anordnung ist wiederum für RX-Frequenzen von Band 66 (Band 4/Band 1/Band 65) ausgelegt.

Im zweiten Diplexer wird am Tiefpass ein Mid-Band- Frequenzbereich von 1425 MHz bis 2025 MHz separiert und über eine zweite, jedoch optionale Extraktor-Anordnung EA2 für Frequenzen zwischen 1452 und 1496 MHz einem ersten Antennenschalter AS1 zugewiesen.

Am Hochpass des zweiten Duplexers DPX2 werden Frequenzen von 2300 MHz bis 2690 MHz einem zweiten Antennenschalter AS2 zugeleitet.

Am Ausgang des ersten Antennenschalters AS1 sind reine Duplexer für Band 2 und Band 3 sowie ein gemischter Duplexer für Band 1 TX/Band 3 RX sowie Band 4 TX/Band 2 RX vorgesehen. Mit Hilfe dieser Anordnung gelingt es, einen Vierfach-Downlink Carrier-Aggregation-Mode von Band 1, Band 3, Band 7 und Band 32 zu ermöglichen. Weiterhin ist ein ebensolcher Vierfach-Carrier-Aggregation-Mode für die Bänder 12 (oder 5 oder 29), 2 (oder 25), 4 und 30 möglich.

In keinem der Fälle ist für diesen Vierfach-Carrier-Aggregation-Mode ein zellularer Quad-oder Hexaplexer erforderlich. Da der zweite vorgeschlagene Vierfach-Downlink Carrier-Aggregation-Mode Band 32 nicht bedienen muss, kann auf die Extraktor-Anordnung für Band 32 auch verzichtet werden. Ebenso kann optional der erste Diplexer DPX1 entfallen, wenn Frequenzen des Low-Band-Bereichs nicht erforderlich sind oder über eine weitere Antenne bedient werden.

Obwohl die Erfindung nur anhand weniger konkreter Ausführungsbeispiele beschrieben werden konnte, ist sie nicht auf diese begrenzt. Erfindungsgemäße Frontend-Module können zusätzliche Elemente enthalten, die hier nicht separat aufgeführt sind. Die Anzahl der Extraktor-Anordnungen kann, wie beispielsweise in Figur 4 vorgeschlagen, entsprechend der Anzahl extrahierbarer Bänder erhöht werden. Die Anzahl der bedienbaren Bänder kann über einen Anschluss entsprechender Filterelemente beliebig erhöht werden, wobei einem Antennenschalter für einen gegebenen Frequenzbereich natürlich nur Filterelemente für diesen Frequenzbereich bzw. für Bänder zugeordnet werden können, die innerhalb dieses Frequenzbereichs liegen.

Jede Extraktor-Anordnung kann optional mit einem Überbrückungspfad versehen sein, sodass sie je nach Betriebsmodus aktiviert oder deaktiviert werden kann
Die Filterelemente am Ausgang der Antennenschalter sowie die Notch-Filter und Bandpassfilter in den Extraktor-Anordnungen umfassen mikroakustische Resonatoren. Die Diplexer können in unterschiedlichen Technologien ausgeführt sein, vorzugsweise integriert in eine LTCC-Keramik oder ein Laminat, wobei die erfindungsgemäße Architektur einen großen Diplexerabstand erlaubt, der mit einfacheren Mitteln realisiert werden kann.

Obwohl stets nur von erfindungsgemäßen Frontend-Modulen die Rede war, können auch einzelne Elemente solcher Module für sich genommen Erfindungen darstellen. Insbesondere sind dies die speziellen gemischten Duplexer oder die Triplexer für Downlink und Uplink Carrier Aggregation- -Betrieb. Auch bereits eine Extraktor-Anordnung, die mit einem optionalen Überbrückungspfad mittels eines darin angeordneten
Schalters aktiviert oder deaktiviert werden kann, kann in anderen Architekturen eingesetzt werden und vorteilhafte Effekte entfalten.

Auch ist es möglich, die Elemente der beschriebenen Frontend-Module auf mehrere Substrate oder Träger aufzuteilen, so dass streng genommen nicht mehr Module sondern Anordnungen vorliegen, die aber ebenfalls als erfindungsgemäße und daher geschützte Gegenstände zu betrachten sind.

Weiterhin umfasst die Erfindung auch noch komplexere Anordnungen, soweit diese die beschriebene Strukturen umfassen, durch Verschalten mit anderen Elementen und Anordnungen aber mit weiteren Funktionen versehen sind.

### Bezugszeichenliste

- SP: erster Signalpfad, verbindet
- AT: Antennenanschluss und
- DPX: Diplexer
- TP: Teilpfade am Diplexer-Ausgang
- EA1: erste Extraktoranordnung mit einem
- NF1: ersten Notchfilter mit
- EP1: ersten Extraktorpfad und darin angeordnetem
- BP1: ersten Bandpassfilter mit einem
- LMB: lower midband
- UEB: Überbrückungspfad mit darin angeordnetem
- SW: Schalter
- AS: Antennenschalter an einem Teil- oder Signalpfad
- LB: Lowband
- MB: Midband
- HB: Highband
- DAT: Diversity Antenne, verbindbar mit
- DRX: Diversity RX Filter

## Patentansprüche

1. Frontend Modul, welches für einen Carrier Aggregation Betrieb ertüchtigt ist, das Frontend Modul umfassend:
- einen ersten Diplexer (DPX2) oder einen höheren Multiplexer,
- einen ersten Antennenanschluss (AT),
- einen ersten Signalpfad (SP), der den ersten Antennenanschluss (AT) mit dem ersten Diplexer (DPX2) beziehungsweise dem höheren Multiplexer verbindet,
- einen zwischen dem ersten Antennenanschluss (AT) und dem ersten Diplexer (DPX2) beziehungsweise höheren Multiplexer im ersten Signalpfad (SP) gekoppelten Notchfilter (NF), der einen ersten Sperrbereich aufweist,
- einen ersten Extraktorpfad (EP1), der an einen im Signalpfad (SP) zwischen Antennenanschluss (AT) und erstem Notchfilter (NF) angeordneten Knoten angekoppelt ist,
- einen Bandpassfilter (BP) für ein erstes Extraktorband, das im ersten Extraktorpfad (EP) angeordnet ist, wobei das Notchfilter (NF) und das Bandpassfilter (BP) eine Extraktoranordnung (EA) ausbilden,
- wobei der Diplexer (DPX2) beziehungsweise der höhere Multiplexer einen ersten und einen zweiten Frequenzbereich, die durch einen ersten Diplexerabstand beziehungsweise Multiplexerabstand beabstandet sind, voneinander trennt und jeweils einem ersten Teilpfad (TP2) oder einem zweiten Teilpfad (TP3) zuweist,
- wobei der Sperrbereich des Notchfilters (NF) und das erste Extraktorband zumindest teilweise überlappen,
- wobei der Sperrbereich des Notchfilters (NF) so zwischen erstem und zweitem Frequenzbereich angeordnet ist, dass er mit keinem der Frequenzbereiche überlappt.

2. Frontend Modul nach Anspruch 1,
bei dem im ersten Signalpfad (SP) zwischen dem ersten Antennenanschluss (AT) und dem Notchfilter (NF) ein zweiter Diplexer (DPX1) oder ein zweiter höherer Multiplexer angeordnet ist, der zumindest einen dritten Frequenzbereich aus dem ersten Signalpfad (SP) abtrennt und in einen dritten Teilpfad (TP1) leitet.

3. Frontend Modul nach einem der vorangehenden Ansprüche,
bei dem der Sperrbereich das Rx Band von Band 66, oder Band 1 oder Band 4 vollständig überlappt,
bei dem das Bandpassfilter (BP) für das Rx Band von Band 66, oder Band 1 oder Band 4 oder Band 65 ausgebildet ist,
bei dem der erste Frequenzbereich Frequenzen bis 1995 MHz oder bis 2025 MHz umfasst,
bei dem der zweite Frequenzbereich Frequenzen von größer gleich 2300 MHz umfasst,
so dass der Extraktorpfad (EP) zur Abtrennung der Rx Frequenzen von Band 66, oder Band 1 oder Band 4 oder Band 65 ausgelegt ist.

4. Frontend Modul nach einem der vorangehenden Ansprüche,
bei dem der Sperrbereich das Band 30 Rx und Tx und/oder Band 40 vollständig überlappt,
bei dem das Bandpassfilter (BP) für Band 30 Rx und Tx und/oder Band 40 ausgebildet ist,
bei dem der erste Frequenzbereich Frequenzen bis 2170 MHz oder bis 2200 MHz umfasst,
bei dem der zweite Frequenzbereich Frequenzen von größer gleich 2496 MHz umfasst, bei dem der Extraktorpfad (EP) zur Abtrennung der Rx Frequenzen von Band 30 und/oder Band 40 ausgelegt ist.

5. Frontend Modul nach einem der vorangehenden Ansprüche,
bei dem ein zweites Notchfilter (NF) im ersten Signalpfad (SP) oder einem Teilpfad (TP), ausgewählt aus dem ersten, zweiten und dritten Teilpfad (TP2, TP3, TP1), angeordnet ist, wobei das Notchfilter einen zweiten Sperrbereich aufweist,
bei dem zwischen Antennenanschluss (AT) und dem zumindest einen weiteren Notchfilter (NF) ein Extraktorpfad (EP) vom ersten Signalpfad (SP) oder dem jeweiligen Teilpfad (TP) abzweigt, in dem ein Bandpassfilter (BP) angeordnet ist, dessen Durchlassbereich einem zweiten Extraktorband entspricht, wobei zweiter Sperrbereich und zweites Extraktorband zumindest teilweise überlappen.

6. Frontend Modul nach einem der vorangehenden Ansprüche,
bei dem zwei Extraktoranordnungen (EA1, EA2) vorgesehen sind, die zum Extrahieren von jeweils einem Extraktorband ausgebildet sind,
bei dem das erste Extraktorband das Rx Band von Band 66 oder Band 1 oder Band 4 oder Band 65 umfasst,
bei dem das zweite Extraktorband für Frequenzen ausgelegt ist, die aus GNSS, WLAN 2.4, Band 40, Band 30, Band 32 und LMB ausgewählt sind, wobei LMB Frequenzen von 1425 bis 1511 MHz umfasst.

7. Frontend Modul nach dem vorangehenden Anspruch,
bei dem drei Extraktoranordnungen (EA1, EA2, EA3) vorgesehen sind, die zum Extrahieren von zusammen drei unterschiedlichen Extraktorbändern ausgebildet sind,
bei dem das erste Extraktorband das Rx Band von Band 66 oder Band 1 oder Band 4 oder Band 65 umfasst,
bei dem das zweite und das dritte Extraktorband für unterschiedliche Frequenzen ausgelegt ist, die unabhängig voneinander aus GNSS, WLAN 2.4, Band 40, Band 30, Band 32 und LMB ausgewählt sind.

8. Frontend Modul nach einem der vorangehenden Ansprüche,
bei dem ein jedes Notchfilter (NF) und ein jedes der in einem der Extraktorpfade (EA) angeordnete Bandpassfilter (BP) mikroakustische Resonatoren umfasst, die ein SAW Filter, ein temperaturkompensiertes SAW Filter oder ein BAW Filter realisieren.

9. Frontend Modul nach einem der vorangehenden Ansprüche,
bei der oder die Diplexer (DPX1, DPX2) Tiefpass, Hochpass- oder Bandpassfilter umfassen, die aus L und C Elementen realisiert sind, die in einer LTCC Keramik oder einem Laminat integriert oder als diskrete L und C Elemente realisiert sind, die auf einem Träger montiert sind.

10. Frontend Modul nach einem der vorangehenden Ansprüche,
bei dem jede der Extraktoranordnungen (EA) mit einem Überbrückungspfad (UEP) überbrückt werden kann, bei dem in jedem Überbrückungspfad (UEP) ein Schalter (SW) zum Öffnen oder Schließen des Überbrückungspfads (UEP) angeordnet ist.

11. Frontend Modul nach einem der vorangehenden Ansprüche,
bei dem einer der Teilpfade (TP) mit dem Eingang eines Antennenschalters (AS) verbunden ist,
bei dem ein Ausgang des Antennenschalters (AS) über eine entsprechende Schalterstellung wahlweise mit einer Reihe von Duplexern verbunden werden kann,
bei dem die Duplexer einen gemischten Duplexer umfassen, der ein Rx Filter für ein erstes Band und ein Tx Filter für ein davon verschiedenes zweites Band kombiniert,
bei dem ein Extraktorband Rx Frequenzen des zweiten Bands umfasst,
bei dem ein weiterer Duplexer ein reiner Duplexer ist, der ein Tx Filter und ein dazugehöriges Rx Filter für das erste Band umfasst.

12. Frontend Modul nach einem der vorangehenden Ansprüche,
mit einem mit einer Diversity Antenne (DAT) verbindbaren reinen Empfangspfad,
mit einer Extraktoranordnung (EA), die vom reinen Empfangspfad einen Extraktorpfad (EP) abzweigt, wobei das Extraktorband B4-Rx, B1-Rx, B65-Rx oder B66-Rx zugeordnet ist,
bei dem im reinen Empfangspfad ein Diplexer (DPX) angeordnet ist, der den reinen Empfangspfad in zwei reine Empfangsteilpfade teilt, die jeweils einem Midband und einem Highband Bereich zugeordnet sind,
bei dem im Empfangsteilpfad für Midband ein gemischter Diversity Triplexer angeordnet ist, der eine Filterkombination für B32-Rx/B21-Rx/B3-Rx aufweist.

13. Frontend Modul nach dem vorangehenden Anspruch,
bei dem zwischen der Diversity Antenne (DAT) und der Extraktoranordnung (EA) ein weiterer Diplexer (DPX) oder höherer Multiplexer angeordnet ist, der vom reinen Empfangspfad einen weiteren Teilpfad (TP) für Frequenzbereich abzweigt.

14. Frontend Modul nach einem der vorangehenden Ansprüche,
bei dem zwei Extraktoranordnungen (EA) vorgesehen sind, die zum Extrahieren von jeweils einem Extraktorband ausgebildet sind,
bei dem das erste Extraktorband das Band 30_Rx und Tx und/oder Band 40 umfasst,
bei dem das zweite Extraktorband für Frequenzen ausgelegt ist, die aus GNSS, WLAN 2.4, Band 66-Rx, Band 32-Rx und LMB ausgewählt sind, wobei LMB Frequenzen von 1425 bis 1511 MHz umfasst.

15. Frontend Modul nach einem der vorangehenden Ansprüche,
bei dem ein gemischter Duplexer mit einer Filterkombination für die Bänder B1- oder B65-Tx / B(11+21+32)-Rx vorgesehen ist.

## Claims

1. Front-end module, which is configured for a carrier aggregation operation, the front-end module comprising:
- a first diplexer (DPX2) or a higher multiplexer,
- a first antenna terminal (AT),
- a first signal path (SP) connecting the first antenna terminal (AT) to the first diplexer (DPX2) or the higher multiplexer, respectively,
- a notch filter (NF) coupled between the first antenna terminal (AT) and the first diplexer (DPX2) or higher multiplexer in the first signal path (SP), wherein the notch filter (NF) comprises a first stopband,
- a first extractor path (EP1) coupled to a node arranged in the signal path (SP) between antenna terminal (AT) and the first notch filter (NF),
- a bandpass filter (BP) for a first extractor band arranged in the first extractor path (EP), wherein the notch filter (NF) and the bandpass filter (BP) form an extractor arrangement (EA),
- wherein the diplexer (DPX2) or the higher multiplexer, respectively, separates a first and a second frequency band, which are spaced by a first diplexer spacing or multiplexer spacing, respectively, and respectively assigns them to a first partial path (TP2) or a second partial path (TP3),
- wherein the stopband of the notch filter (NF) and the first extractor band overlap at least partially,
- wherein the stopband of the notch filter (NF) is arranged between the first and the second frequency band such that it does not overlap with any of the frequency bands.

2. Front-end module according to claim 1,
wherein a second diplexer (DPX1) or a second higher multiplexer is arranged in the first signal path (SP) between the first antenna terminal (AT) and the notch filter (NF), and separates at least a third frequency range from the first signal path (SP) and provides it at a third partial path (TP1).

3. Front-end module according to one of the preceding claims,
wherein the stopband completely overlaps the Rx band of band 66, or band 1, or band 4,
wherein the bandpass filter (BP) is designed for the Rx band of band 66, or band 1, or band 4, or band 65,
wherein the first frequency range comprises frequencies up to 1995 MHz or up to 2025 MHz,
wherein the second frequency range comprises frequencies of greater than or equal to 2300 MHz,
such that the extractor path (EP) is designed to isolate the Rx frequencies of band 66, or band 1, or band 4, or band 65.

4. Front-end module according to one of the preceding claims,
wherein the stopband completely overlaps the band 30 Rx and Tx and/or band 40,
wherein the bandpass filter (BP) is designed for band 30 Rx and Tx and/or band 40,
wherein the first frequency range comprises frequencies of up to 2170 MHz or up to 2200 MHz,
wherein the second frequency range comprises frequencies of greater than or equal to 2496 MHz, in which the extractor path (EP) is designed to isolate the Rx frequencies of band 30 and/or band 40.

5. Front-end module according to one of the preceding claims, wherein a second notch filter (NF) is arranged in the first signal path (SP) or a partial path (TP) selected from the first, second and third partial path (TP2, TP3, TP1), the notch filter (NF) comprising a second blocking region, wherein an extractor path (EP) branches off between the antenna terminal (AT) and the at least one further notch filter (NF) from the first signal path (SP) or the respective partial path (TP) in which a bandpass filter (BP) is arranged, the passband of which is a second extractor band, wherein the second stopband and the second extractor band being at least partly overlapping.

6. Front-end module according to one of the preceding claims, wherein two extractor arrangements (EA1, EA2) are provided, which are designed for extracting one extractor band each, wherein the first extractor band comprises the Rx band of band 66, or band 1, or band 4, or band 65,
wherein the second extractor band is designed for frequencies selected from GNSS, WLAN 2.4, band 40, band 30, band 32, and LMB, wherein LMB comprises frequencies of 1425 to 1511 MHz.

7. Front-end module according to the preceding claim, wherein three extractor arrangements (EA1, EA2, EA3) are provided, which are designed for extracting together three different extractor bands, wherein the first extractor band comprises the Rx band of band 66, or band 1, or band 4, or band 65,
wherein the second and third extractor bands are designed for different frequencies which are independently selected from GNSS, WLAN 2.4, band 40, band 30, band 32, and LMB.

8. Front-end module according to one of the preceding claims, wherein each of said notch filters (NF) and each of said bandpass filters (BP) arranged in one of said extractor paths (EP) comprises micro-acoustic resonators realizing an SAW filter, a temperature-compensated SAW filter or a BAW filter.

9. Front-end module according to one of the preceding claims, wherein the one or the more diplexers (DPX1, DPX2) comprise lowpass, highpass or bandpass filters realized from L and C elements integrated into an LTCC ceramic or a laminate or realized as discrete L and C elements mounted on a carrier.

10. Front-end module according to one of the preceding claims, wherein each of the extractor arrangements (EA) can be bypassed with a bypassing path (UEP), wherein a switch (SW) is arranged in each bypassing pass (UEP) for opening or closing the bypassing path (UEP).

11. Front-end module according to one of the preceding claims, wherein one of the partial paths (TP) is connected to the input of an antenna switch (AS),
wherein an output of the antenna switch (AS) can optionally be connected via a corresponding switch position to a series of duplexers, wherein the duplexers comprise a mixed duplexer combining an Rx filter for a first band and a Tx filter for a second band different therefrom, wherein an extractor band comprises Rx frequencies of the second band, wherein another duplexer is a pure duplexer comprising a Tx filter and a corresponding Rx filter for the first band.

12. Front-end module according to one of the preceding claims, with a pure receiving path which can be connected to a diversity antenna (DAT),
with an extractor arrangement (EA) which branches off an extractor path (EP) from the pure receiving path, the extractor band being assigned to B4-Rx, B1-Rx, B65-Rx or B66-Rx,
wherein a diplexer (DPX) is arranged in the pure reception path dividing the pure reception path into two pure reception partial paths, which are respectively assigned to a mid-band (MB) and a high-band (HB) range, wherein a mixed diversity triplexer is arranged in the reception partial path for mid-band (MB) and comprising a filter combination for B32-Rx / B21-Rx / B3-Rx.

13. Front-end module according to the preceding claim, wherein a further diplexer (DPX) or higher multiplexer, which branches off a further partial path (TP) for a frequency range from the pure reception path, is arranged between the diversity antenna (DAT) and the extractor arrangement (EA).

14. Front-end module according to one of the preceding claims, wherein two extractor arrangements (EA) are provided, which are designed for extracting one extractor band each, wherein the first extractor band comprises the band 30_Rx and Tx and/or band 40,
wherein the second extractor band is designed for frequencies selected from GNSS, WLAN 2.4, Band 66-Rx, Band 32-Rx and LMB, wherein LMB comprises frequencies of 1425 to 1511 MHz.

15. Front-end module according to one of the preceding claims, wherein a mixed duplexer is provided with a filter combination for the bands B1- or B65-Tx / B(11+21+32)-Rx.

## Revendications

1. Module frontal, lequel est adapté à un mode agrégation de porteuses, le module frontal comprenant :
- un premier diplexeur (DPX2) ou un multiplexeur supérieur,
- une première borne d'antenne (AT),
- un premier chemin de signal (SP), qui relie la première borne d'antenne (AT) au premier diplexeur (DPX2) ou au multiplexeur supérieur,
- un filtre coupe-bande (NF) couplé entre la première borne d'antenne (AT) et le premier diplexeur (DPX2) ou multiplexeur supérieur dans le premier chemin de signal (SP), qui présente une première zone de blocage,
- un premier chemin d'extraction (EP1), qui est couplé à un nœud disposé dans le chemin de signal (SP) entre la borne d'antenne (AT) et le premier filtre coupe-bande (NF),
- un filtre passe-bande (BP) pour une première bande d'extraction, qui est disposée dans le premier chemin d'extraction (EP), dans lequel le filtre coupe-bande (NF) et le filtre passe-bande (BP) forment un ensemble d'extracteur (EA),
- dans lequel le diplexeur (DPX2) ou le multiplexeur supérieur sépare une première et une deuxième plage de fréquences qui sont espacées l'une de l'autre d'une première distance de diplexeur ou distance de multiplexeur, et les assigne chacune à un premier chemin partiel (TP2) ou un deuxième chemin partiel (TP3),
- dans lequel la zone de blocage du filtre coupe-bande (NF) et la première bande d'extraction se recouvrent au moins partiellement,
- dans lequel la zone de blocage du filtre coupe-bande (NF) est disposée entre la première et la deuxième plage de fréquences, de sorte qu'elle ne recouvre aucune des plages de fréquence.

2. Module frontal selon la revendication 1,
dans lequel un deuxième diplexeur (DPX1) ou un deuxième multiplexeur supérieur, qui sépare au moins une troisième plage de fréquences du premier chemin de signal (SP) et l'achemine dans un troisième chemin partiel (TP1), est disposé dans le premier chemin de signal (SP) entre la première borne d'antenne (AT) et le filtre coupe-bande (NF).

3. Module frontal selon l'une des revendications précédentes,
dans lequel la zone de blocage recouvre complètement la bande Rx de la bande 66, ou de la bande 1 ou de la bande 4,
dans lequel le filtre passe-bande (BP) est conçu pour la bande Rx de la bande 66, ou de la bande 1 ou de la bande 4 ou de la bande 65,
dans lequel la première plage de fréquences comprend des fréquences jusqu'à 1995 MHz ou jusqu'à 2025 MHz,
dans lequel la deuxième plage de fréquences comprend des fréquences supérieures ou égales à 2300 MHz,
de sorte que le chemin d'extraction (EP) soit conçu pour séparer les fréquences Rx de la bande 66, ou de la bande 1 ou de la bande 4 ou de la bande 65.

4. Module frontal selon l'une des revendications précédentes,
dans lequel la zone de blocage recouvre complètement la bande 30 Rx et Tx et/ou la bande 40,
dans lequel le filtre passe bande (BP) est conçu pour la bande 30 Rx et Tx et/ou la bande 40,
dans lequel la première plage de fréquences comprend des fréquences jusqu'à 2170 MHz ou jusqu'à 2200 MHz,
dans lequel la deuxième plage de fréquences comprend des fréquences supérieures ou égales à 2496 MHz, dans lequel le chemin d'extraction (EP) est conçu pour séparer les fréquences Rx de la bande 30 et/ou de la bande 40.

5. Module frontal selon l'une des revendications précédentes,
dans lequel un deuxième filtre coupe-bande (NF) est disposé dans le premier chemin de signal (SP) ou un chemin partiel (TP), choisi parmi le premier, le deuxième et le troisième chemin partiel (TP2, TP3, TP1), dans lequel le filtre coupe-bande présente une deuxième zone de blocage,
dans lequel, entre la borne d'antenne (AT) et l'au moins un autre filtre coupe-bande (NF), un chemin d'extraction (EP) dérive du premier chemin de signal (SP) ou du chemin partiel (TP) respectif dans lequel est disposé un filtre passe-bande (BP) dont la zone de passage correspond à une deuxième bande d'extraction, dans lequel la deuxième zone de blocage et la deuxième bande d'extraction se recouvrent au moins partiellement.

6. Module frontal selon l'une des revendications précédentes,
dans lequel deux ensembles d'extracteur (EA1, EA2) sont prévus, qui sont conçus pour extraire chacun une bande d'extraction,
dans lequel la première bande d'extraction comprend la bande Rx de la bande 66 ou de la bande 1 ou de la bande 4 ou de la bande 65,
dans lequel la deuxième bande d'extraction est conçue pour des fréquences qui sont choisies parmi GNSS, WLAN 2.4, bande 40, bande 30, bande 32 et LMB, dans lequel LMB comprend des fréquences de 1425 à 1511 MHz.

7. Module frontal selon la revendication précédente,
dans lequel trois ensembles d'extracteur (EA1, EA2, EA3) sont prévus, qui sont conçus pour extraire ensemble trois bandes d'extraction différentes,
dans lequel la première bande d'extraction comprend la bande Rx de la bande 66 ou de la bande 1 ou de la bande 4 ou de la bande 65,
dans lequel la deuxième et la troisième bande d'extraction est conçue pour différentes fréquences qui sont choisies indépendamment les unes des autres parmi GNSS, WLAN 2.4, bande 40, bande 30, bande 32 et LMB.

8. Module frontal selon l'une des revendications précédentes,
dans lequel chaque filtre coupe-bande (NF) et chacun des filtres passe-bande (BP) disposés dans un des chemins d'extraction (EA) comporte des résonateurs microacoustiques, qui forment un filtre SAW, un filtre SAW compensé en température ou un filtre BAW.

9. Module frontal selon l'une des revendications précédentes,
pour le ou les diplexeurs (DPX1, DPX2) comprennent des filtres passe-bas, passe-haut ou passe-bande, qui sont réalisés à partir d'éléments L et C, qui sont intégrés dans une céramique LTCC ou un stratifié, ou réalisés en tant qu'éléments L et C discrets qui sont montés sur un support.

10. Module frontal selon l'une des revendications précédentes,
dans lequel chacun des ensembles d'extracteurs (EA) peut être ponté avec un chemin de pontage (UEP), dans lequel un commutateur (SW) est disposé dans chaque chemin de pontage (UEP) pour ouvrir ou fermer le chemin de pontage (UEP).

11. Module frontal selon l'une des revendications précédentes,
dans lequel l'un des chemins partiels (TP) est relié à l'entrée d'un commutateur d'antenne (AS),
dans lequel une sortie du commutateur d'antenne (AS) peut être reliée au choix à une rangée de duplexeurs par l'intermédiaire d'une position de commutateur correspondante,
dans lequel les duplexeurs comprennent un duplexeur mixte, qui combinent un filtre Rx pour une première bande et un filtre Tx pour une deuxième bande différente de celle-ci,
dans lequel une bande d'extraction comprend des fréquences Rx de la deuxième bande,
dans lequel un duplexeur supplémentaire est un duplexeur pur, qui comprend un filtre Tx et un filtre Rx associé pour la première bande.

12. Module frontal selon l'une des revendications précédentes,
avec un chemin de réception pur pouvant être relié à une antenne à diversité (DAT),
avec un ensemble d'extracteur (EA), qui dérive un chemin d'extraction (EP) du chemin de réception pur, dans lequel la bande d'extraction est associée à B4-Rx, B1-Rx, B65-Rx ou B66-Rx,
dans lequel un diplexeur (DPX) est disposé dans le chemin de réception pur, qui divise le chemin de réception pur en deux chemins partiels de réception purs, qui sont chacun associés à une plage de bande moyenne et à une plage de bande haute,
dans lequel un triplexeur à diversité mixte, qui présente une combinaison de filtres pour B32-Rx/B21-Rx/B3-Rx, est disposé dans le chemin partiel de réception pour la bande moyenne.

13. Module frontal selon la revendication précédente,
dans lequel un autre multiplexeur (DPX) ou un multiplexeur supérieur, qui dérive un autre chemin partiel (TP) du chemin de réception pur pour la plage de fréquences, est disposé entre l'antenne à diversité (DAT) et l'ensemble d'extracteur (EA).

14. Module frontal selon l'une des revendications précédentes, dans lequel deux ensembles d'extracteur (EA) sont prévus, qui sont conçus pour extraire chacun une bande d'extraction,
dans lequel la première bande d'extraction comprend la bande 30_Rx et Tx et/ou la bande 40,
dans lequel la deuxième bande d'extraction est conçue pour des fréquences qui sont choisies parmi GNSS, WLAN 2.4, bande 66-Rx, bande 32-Rx et LMB, dans lequel LMB comprend des fréquences de 1425 à 1511 MHz.

15. Module frontal selon l'une des revendications précédentes,
dans lequel un duplexeur mixte avec une combinaison de filtres est prévu pour les bandes B1- ou B65-Tx/B(11+21+32)-Rx.
